Europäisches Patentamt

European Patent Office

Office européen des brevets

(19)

(11) EP 0 500 473 B1

(12) FASCICULE DE BREVET EUROPEEN

(45) Date de publication et mention
de la délivrance du brevet:
**28.08.1996 Bulletin 1996/35**

(51) Int Cl.6: **H03L 7/087**, H04L 7/033

(21) Numéro de dépôt: **92400472.4**

(22) Date de dépôt: **24.02.1992**

(54) **Comparateur de phase/fréquence pour circuit de récupération de rythme**

Phasen/Frequenzkomparator für Taktrückgewinnungssystem

Phase/frequency comparator for a clock recovery circuit

(84) Etats contractants désignés:
**DE GB IT**

(30) Priorité: **22.02.1991 FR 9102175**

(43) Date de publication de la demande:
**26.08.1992 Bulletin 1992/35**

(73) Titulaire: **SAT (Société Anonyme de Télécommunications)**
**F-75116 Paris (FR)**

(72) Inventeurs:
• **Sari, Hikmet**
**F-75625 Paris Cedex 13 (FR)**
• **Houeix, Hervé François**
**F-75625 Paris Cedex 13 (FR)**

(74) Mandataire: **Cabinet Martinet & Lapoux**
**BP 405**
**78055 Saint Quentin en Yvelines Cédex (FR)**

(56) Documents cités:
EP-A- 0 054 322        GB-A- 2 061 654
US-A- 4 222 013

**Description**

La présente invention concerne de manière générale la récupération du rythme d'un signal d'entrée numérique à une extrémité de réception d'un réseau de communication numérique, et plus particulièrement un comparateur de phase/fréquence inclus dans un circuit de récupération du rythme.

Une fonction de base de tout récepteur inclus dans un système de transmission numérique est de récupérer un signal d' horloge locale pour régénérer les bits d'un signal numérique d'entrée reçu. L'extrémité de réception décide de la valeur probable d'un élément binaire dudit signal d'entrée en échantillonnant le signal d'entrée en fonction du signal d'horloge. Le signal d'entrée est par exemple un signal vidéo transmis sous forme numérique dans un support à fibre optique.

Le circuit de récupération de rythme (ou d'horloge) est généralement conçu sous la forme d'un circuit à boucle de verrouillage de phase.

Un tel circuit de récupération de rythme comprend essentiellement un comparateur de phase, un moyen intermédiaire principalement de filtrage passe-bas, et un oscillateur local commandé en tension produisant un signal d'horloge. Les caractéristiques du circuit de récupération dépendent notamment du comparateur utilisé. L'un des problèmes essentiels liés à la transmission numérique étant la génération du signal d'horloge pour échantillonner le signal d'entrée reçu dans l'extrémité de réception, la fréquence et la phase du signal d'horloge doivent être synchronisées avec celles du signal d'entrée.

Le signal d'horloge locale est initialement asynchrone avec le signal d'entrée, et le circuit de récupération de rythme est destiné à verrouiller le signal d'horloge sur la fréquence dudit signal d'entrée.

Le verrouillage en fréquence a lieu à l'issu d'une phase d'acquisition si l'écart initial entre les fréquences respectives des signaux d'horloge et d'entrée aux extrémités d'émission et de réception est inférieur à une valeur prédéterminée, celle-ci étant fonction des paramètres du circuit de récupération de rythme.

L'écart de fréquence maximal pour lequel le verrouillage du signal d'horloge locale avec le signal d'entrée reçu est acquis est appelé plage d'acquisition ou d'accrochage. Pour un bon fonctionnement du circuit de récupération de rythme dans l'extrémité de réception, il est nécessaire que la plage d'acquisition soit plus grande qu'un intervalle d'incertitude lié à la précision de l'oscillateur utilisé dans l'extrémité d'émission.

Par exemple, pour un système de transmission à 140 Mbit/s dans lequel une extrémité d'émission utilise une horloge avec une précision en fréquence de $\pm\,10^{-4}$, la plage d'acquisition de l'oscillateur local dans l'extrémité de réception ne doit pas être inférieure à $2 \times 140 \times (10^3 \times 10^{-4}) \cong 28$ kHz.

Ainsi, un bon fonctionnement du circuit récepteur est garanti pour des variations données de la fréquence d'émission, par "adaptation" de l'oscillateur local dans l'extrémité de réception à la fréquence du signal reçu durant la phase d'acquisition en réponse par exemple à un saut de fréquence.

Après l'achèvement de ce verrouillage en fréquence, il est nécessaire que le signal d'horloge locale récupérée présente une faible gigue de phase. En effet, des déphasages entre le signal d'horloge régénérée verrouillée et le signal reçu à régénérer doivent être suffisament faibles pour ne pas dégrader les performances du système de transmission à l'état permanent après acquisition en fréquence.

Or, selon la technique antérieure, l'augmentation de la plage d'acquisition en fréquence et la diminution du bruit de phase à l'état permanent sont des contraintes antagonistes, et dans un bon nombre d'applications il est difficile voire même impossible de trouver un compromis satisfaisant sans avoir recours à des techniques d'aide à l'acquisition.

Une technique connue d'aide à l'acquisition est un balayage en fréquence qui consiste, lors de la phase d'acquisition, à balayer la fréquence nominale de l'oscillateur local dans l'intervalle d'incertitude de la fréquence du signal reçu, à l'aide d'un signal externe qui est inhibé dès que l'acquisition à lieu. Le circuit de récupération de rythme est alors verrouillé sur la fréquence du signal reçu. Or, il est bien connu de l'homme du métier que le balayage en fréquence présente l'inconvénient de ralentir la phase d'acquisition, notamment dans une chaîne de transmission comprenant plusieurs circuits de récupération de rythme.

La présente invention vise principalement à résoudre les inconvénients de la technique antérieure décrits ci-dessus en fournissant un comparateur de phase/fréquence à inclure dans un circuit de récupération de rythme afin que ce circuit autorise de larges plages d'acquisition de fréquence et garantisse une faible gigue de phase du signal d'horloge régénérée.

A cette fin, un comparateur de phase/fréquence comprenant des moyens de comparaison de phase comparant les phases d'un signal numérique d'entrée ayant une période binaire prédéterminée et d'un signal d'horloge ayant une période d'horloge variable à un intervalle de temps prédéterminé près par rapport à ladite période binaire afin de produire un premier signal d'erreur dont le signe est fonction du signe de la différence de phase entre le signal d'entrée et le signal d'horloge est caractérisé en ce qu'il comprend des moyens d'évaluation de phase pour détecter un déphasage prédéterminé entre le signal d'horloge et le signal d'entrée à l'intervalle de temps prédéterminé près pendant une période d'horloge afin de produire un signal de détection de phase, et des moyens pour modifier le premier signal d'erreur en un second signal d'erreur dont le signe est fonction du signe de la différence entre la période binaire et la période d'horloge, en réponse au signal de détection de phase.

De préférence, pour des simplifications de la circuiterie du comparateur, le déphasage prédéterminé est sensiblement égal à zéro à l'intervalle de temps prédéterminé de variation de période d'horloge près. Dans ce cas, les moyens d'évaluation de phase peuvent comprendre des moyens pour détecter des transitions entre états logiques dans le signal d'entrée afin de produire des impulsions de transition ayant une largeur sensiblement égale à l'intervalle de temps prédéterminé, et des moyens pour produire une impulsion du signal de détection de phase ayant une largeur au moins égale à une période d'horloge en réponse à une impulsion de transition sensiblement en phase avec un signal d'horloge complémentaire dudit signal d'horloge.

Selon d'autres variantes, les moyens d'évaluation de phase détectent plusieurs déphasages prédéterminés entre le signal d'horloge et le signal d'entrée pendant plusieurs périodes d'horloges respectives afin de produire le signal de détection de phase même lorsque le signal d'entrée comprend des suites de bits consécutifs ayant le même état logique. Par exemple les déphasages prédéterminés peuvent être sensiblement égaux à 0 et $\Pi$ modulo $2\Pi$.

Les moyens pour modifier le premier signal d'erreur en le second signal d'erreur dépendent du type des moyens de comparaison de phase.

Lorsque les moyens de comparaison de phase sont du type signe, c'est-à-dire lorsque le premier signal d'erreur a deux états logiques ou polarités représentatifs du signe du déphasage entre le signal d'entrée et le signal d'horloge, les moyens pour modifier comprennent des moyens pour reproduire au moins une période du signal d'horloge en réponse au signal de détection de phase, et des moyens pour lire le signe du premier signal d'erreur en réponse à la période de signal d'horloge reproduite afin d'établir le second signal d'erreur. Le second signal d'erreur a alors des états représentatifs du signe de la différence des fréquences du signal d'horloge et du signal d'entrée.

Les moyens de comparaison de phase qui sont inclus dans un comparateur de phase/fréquence selon l'invention, peuvent être du type linéaire. Le premier signal d'erreur varie en signe et grandeur en fonction du déphasage entre le signal d'horloge et le signal d'entrée. Les moyens de comparaison de phase comprennent des moyens pour établir des premières impulsions ayant des largeurs qui varient en fonction du déphasage entre le signal d'horloge et le signal d'entrée, des moyens pour établir des secondes impulsions ayant des largeurs proportionnelles à la période d'horloge, et un moyen d'amplification différentielle. Les moyens pour modifier comprennent des moyens pour comparer les largeurs de première et seconde impulsions en réponse au signal de détection de phase afin de produire un signal de signe logique dont les états sont représentatifs du signe de la différence entre la période binaire et la période d'horloge, et des moyens pour sélectionner des première et seconde impulsions pendant au moins une période d'horloge déterminée par le signal de détection de phase de manière à produire des premier et second signaux reproduisant respectivement les première et seconde impulsions sélectionnées contenues dans la période d'horloge déterminée et l'état du signal de signe et l'état inverse du signal de signe de part et d'autre de la période d'horloge déterminée, lesdits premier et second signaux étant appliqués audit moyen d'amplification différentielle qui produit le second signal d'erreur.

Les caractéristiques ci-dessus de comparateurs de phase/fréquence ainsi que d'autres sont définies dans les revendications 1 à 13. L'invention concerne également un circuit de récupération de rythme comprenant un circuit de boucle de verrouillage de phase incluant un comparateur de phase qui est un comparateur de phase/fréquence selon l'invention.

D'autres avantages de l'invention apparaîtront plus clairement à la lecture de la description suivante de plusieurs réalisations préférées selon l'invention en référence aux dessins annexés correspondants dans lesquels :

- la figure 1 est un bloc-diagramme schématique d'un circuit de récupération de rythme à boucle de verrouillage de phase selon la technique antérieure;
- la figure 2A est un bloc-diagramme d'un premier comparateur de phase de type signe selon la technique antérieure;
- les figures 2B et 2C sont des diagrammes temporels de signaux relatifs au premier comparateur de phase;
- la figure 3 est un bloc-diagramme d'un second comparateur de phase de type signe selon la technique antérieure;
- la figure 4A est un bloc-diagramme d'un comparateur de phase de type linéaire selon la technique antérieure;
- les figures 4B et 4C sont des diagrammes temporels de signaux concernant le comparateur de phase de la figure 4A respectivement lorsque le signal d'horloge récupérée est en avance et en retard par rapport au signal numérique d'entrée;
- la figure 5A est un bloc-diagramme d'un premier comparateur de phase/fréquence de type signe selon l'invention;
- les figures 5B et 5C sont des diagrammes temporels de signaux concernant le comparateur de la figure 5A respectivement lorsque la fréquence du signal d'entrée est supérieure et inférieure à la fréquence du signal d'horloge récupérée, en correspondance avec les figures 2B et 2C;
- la figure 5D est un diagramme de phase relatif au comparateur de la figure 5A;
- la figure 5E montre trois diagrammes de signal de commande d'oscillateur en fonction du déphasage entre signal d'entrée et signal d'horloge, respectivement relatifs au comparateur de phase de la figure 2A et à des écarts de fréquence positif et négatif entre signal d'entrée et signal d'horloge pour le comparateur de phase/fréquence de la figure 5A;

- la figure 6 est un bloc-diagramme d'un second comparateur de phase/fréquence de type signe selon l'invention;
- la figure 7A est un bloc-diagramme d'un premier comparateur de phase/fréquence de type linéaire selon l'invention;
- les figures 7B et 7C sont les diagrammes temporels de signaux concernant le comparateur de la figure 7A respectivement lorsque la fréquence du signal d'entrée est supérieure et inférieure à la fréquence du signal d'horloge récupérée;
- les figures 7D et 7E montrent deux diagrammes de signal de commande d'oscillateur en fonction du déphasage entre signal d'entrée et signal d'horloge respectivement relatifs à des écarts de fréquence positif et négatif entre signal d'entrée et signal d'horloge pour le comparateur de phase/fréquence de la figure 7A;
- la figure 8A est un bloc-diagramme d'un second comparateur de phase/fréquence de type linéaire selon l'invention; et
- les figures 8B et 8C montrent deux diagrammes de signal de commande d'oscillateur en fonction du déphasage entre signal d'entrée et signal d'horloge respectivement relatifs à des écarts de fréquence positif et négatif entre signal d'entrée et signal d'horloge pour le comparateur de phase/fréquence de la figure 8A.

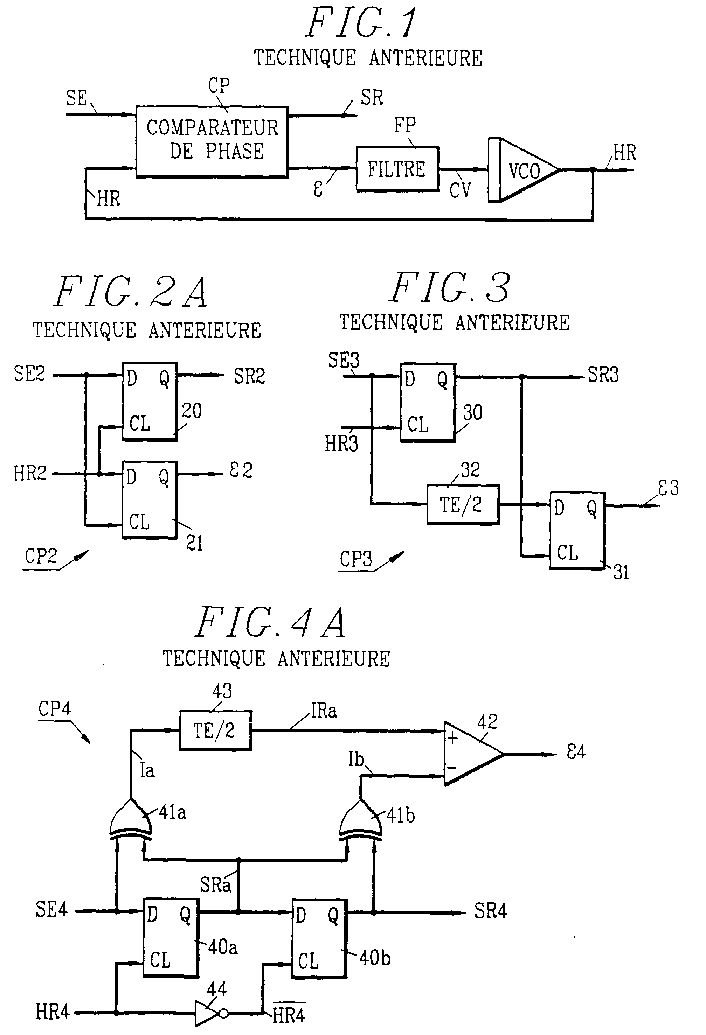

En référence à la figure 1, un circuit de récupération de rythme connu du type à boucle de verrouillage de phase comprend essentiellement un comparateur de phase CP, un filtre passe-bas FP et un oscillateur local commandé en tension VCO. La sortie de l'oscillateur produit un signal d'horloge récupérée HR appliqué à une première entrée du comparateur. Une seconde entrée du comparateur CP reçoit un signal numérique d'entrée SE à régénérer. Le comparateur fournit un signal d'erreur $\varepsilon$ en fonction du déphasage entre le signal d'horloge récupérée HR et le signal d'entrée SE. Un signal numérique régénéré SR en phase avec le signal d'horloge HR est également produit par le comparateur CP. Le filtre FP ou tout autre moyen de filtrage à composants numériques/analogiques et à multiplicateur ou diviseur de fréquence assure une double fonction consistant en la stabilisation de la tension de commande CV de l'oscillateur et la rejection des composantes hautes fréquences du signal d'erreur $\varepsilon$. Le signal d'horloge récupérée HR est asservi au signal d'entrée SE pour établir des instants d'échantillonnage du signal numérique d'entrée. Selon que le signal d'horloge est en avance ou en retard de phase par rapport au signal d'entrée, une correction de phase correspondante représentée par l'amplitude du signal de commande CV est appliquée à l'oscillateur asservi.

Les figures 2A, 3 et 4A montrent respectivement des comparateurs de phase CP2, CP3 et CP4 selon la technique antérieure comportant des bascules de type D.

Le plus simple d'entre eux, le comparateur CP2, comprend deux bascules D 20 et 21 comme montré à la figure 2A.

La première bascule 20 reçoit le signal numérique d'entrée SE2 à régénérer et le signal d'horloge récupérée HR2 fourni par l'oscillateur local VCO par une entrée D et une entrée d'horloge CL respectivement. Une sortie Q de la bascule 20 produit un signal numérique régénéré SR2.

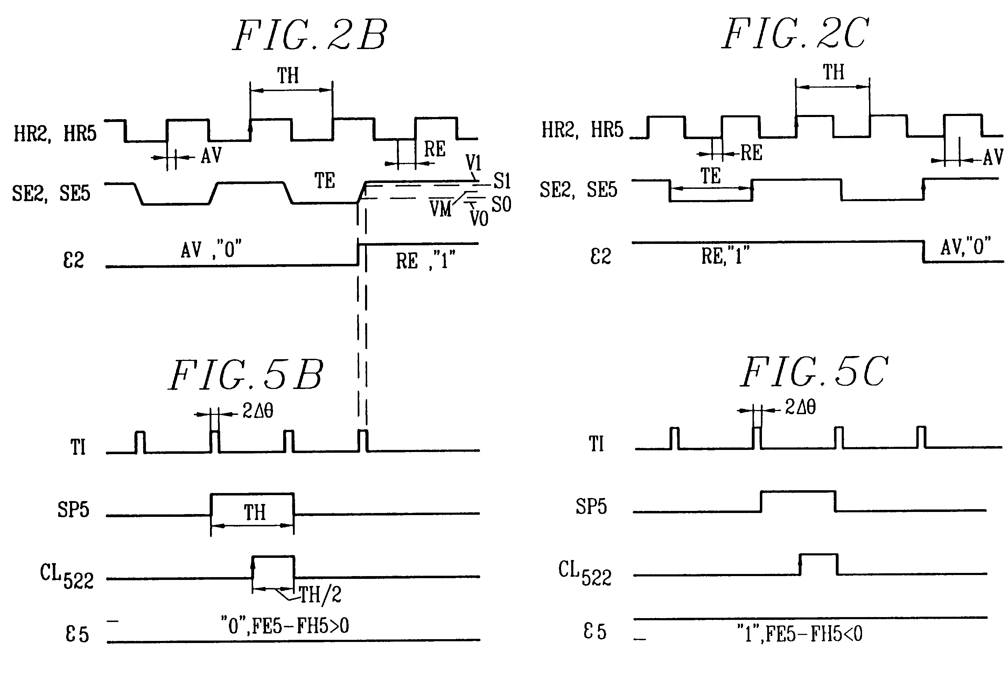

La seconde bascule 21 offre une entrée D reliée à la sortie de l'oscillateur local commandé en tension VCO pour recevoir le signal d'horloge récupérée HR2, et une entrée d'horloge CL recevant le signal d'entrée à régénérer SE2. Ainsi, des fronts montants du signal SE2 échantillonnent le signal d'horloge HR2 en un signal d'erreur $\varepsilon 2$ produit par une sortie Q de la bascule 21. Comme montré à gauche dans la figure 2B et à droite dans la figure 2C, lorsque le signal d'horloge récupérée est en avance de phase AV sur le signal d'entrée, c'est-à-dire lorsque les fronts montants du signal d'horloge sont en avance par rapport au milieu des périodes binaires du signal d'entrée, le signal d'erreur $\varepsilon 2$ est à l'état "O" afin de retarder le signal d'horloge récupérée par l'oscillateur local. Dans le cas d'un retard de phase RE montré à droite dans la figure 2B et à gauche dans la figure 2C, le signal d'erreur $\varepsilon 2$ est à l'état "1" afin d'avancer le signal d'horloge HR2. Le comparateur CP2 fournit ainsi un signal d'erreur $\varepsilon 2$ dont les états logiques sont représentatifs du signe de la différence de phase entre le signal d'horloge récupérée HR2 et le signal d'entrée SE2 pour recaler le signal d'horloge afin que les fronts montants du signal d'horloge coïncident avec le milieu des périodes binaires TE du signal numérique d'entrée SE2. Un comparateur, tel que le comparateur CP2, est appelé "comparateur de phase de type signe".

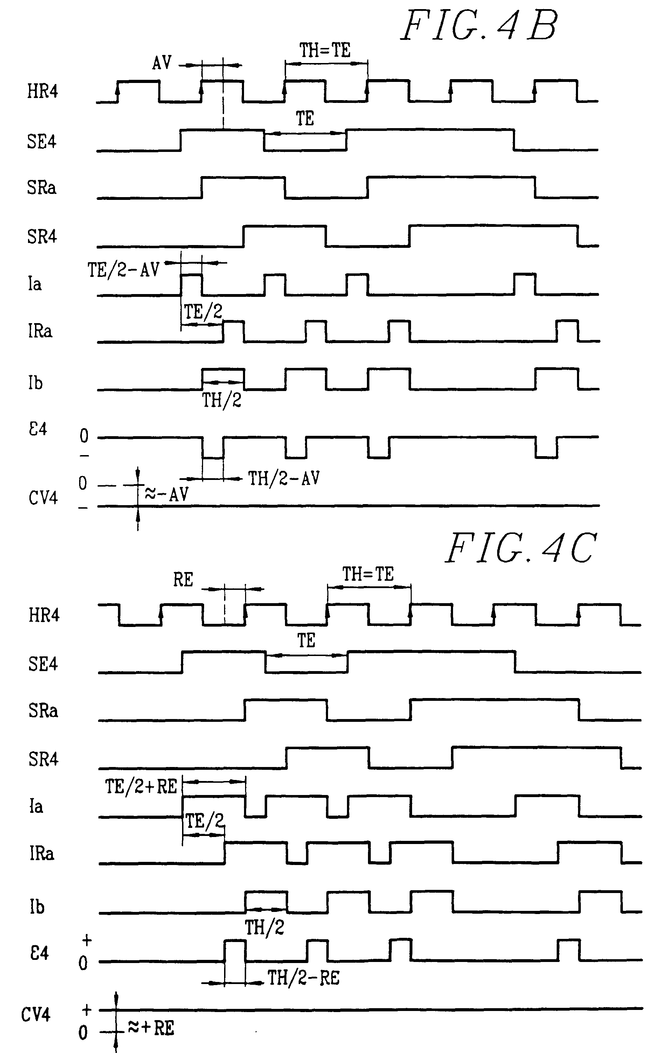

La figure 3 montre un autre comparateur de phase de type signe CP3 comprenant deux bascules D 30 et 31 et une ligne à retard de TE/2, 32. La première bascule 30 est équivalente à la bascule 20 et établit en sortie Q un signal numérique régénéré SR3 en fonction d'un signal numérique d'entrée SE3 et d'un signal d'horloge récupérée HR3 appliqués aux entrées D et CL de la bascule 30, respectivement. L'entrée CL de la seconde bascule 31 est reliée à la sortie Q de la bascule 30. L'entrée D de la bascule 31 reçoit le signal SE3 à travers la ligne à retard 32. Le signal d'entrée SE3 est mis en phase par le signal d'horloge récupérée HR3 dans la première bascule 30 en un signal régénéré SR3, et est déphasé de TE/2 par la ligne à retard 32 en un signal déphasé. Le signal régénéré et le signal déphasé sont respectivement appliqués à l'entrée d'horloge CL et à l'entrée D de la seconde bascule 31 qui génère en sortie Q un signal d'erreur $\varepsilon 3$. Le signal $\varepsilon 3$ est à l'état "1" si le signal d'horloge récupérée est en retard de phase sur le signal d'entrée, et à l'état "O" si le signal d'horloge récupérée est en avance de phase sur le signal d'entrée. La sortie Q de la bascule 31 asservit l'oscillateur local VCO à la phase du signal d'entrée.

Ainsi, le signal d'erreur dans le comparateur CP3 est établi par rapport aux fronts montants du signal régénéré SR3 qui est en phase avec le signal d'horloge HR3 et qui est comparé au signal d'entrée déphasé d'une demi-période binaire TE/2.

Les deux comparateurs de phase CP2 et CP3 ne génèrent en sortie que des signaux d'erreur ayant des états "O" et "1" représentatifs du signe de la différence de phase entre le signal d'horloge récupérée et le signal d'entrée pour asservir l'oscillateur local VCO à la phase du signal d'entrée.

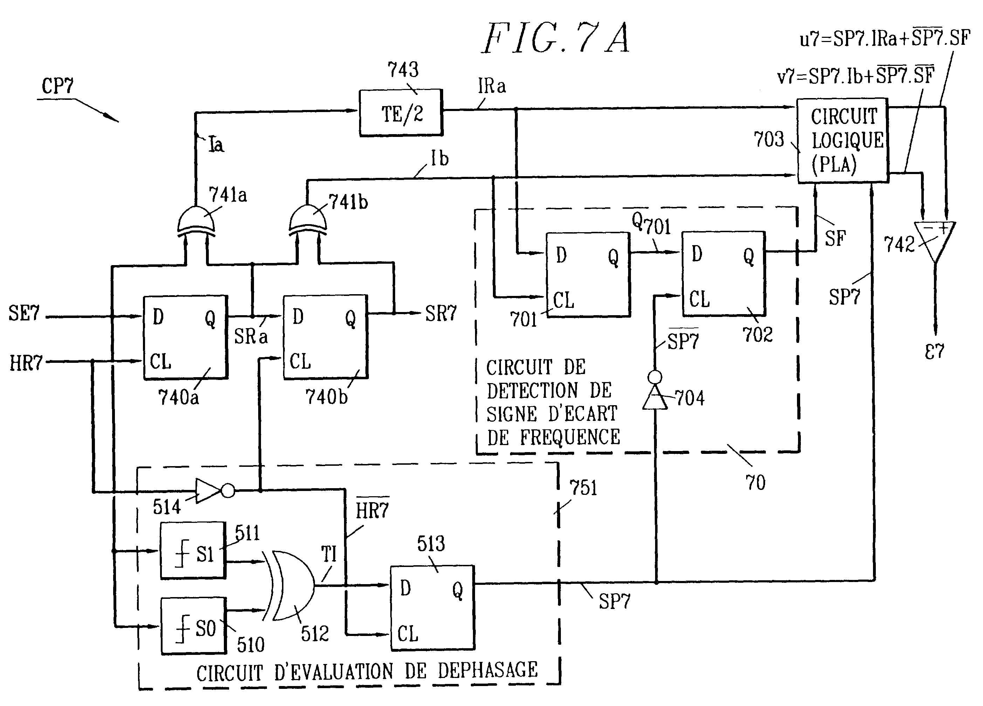

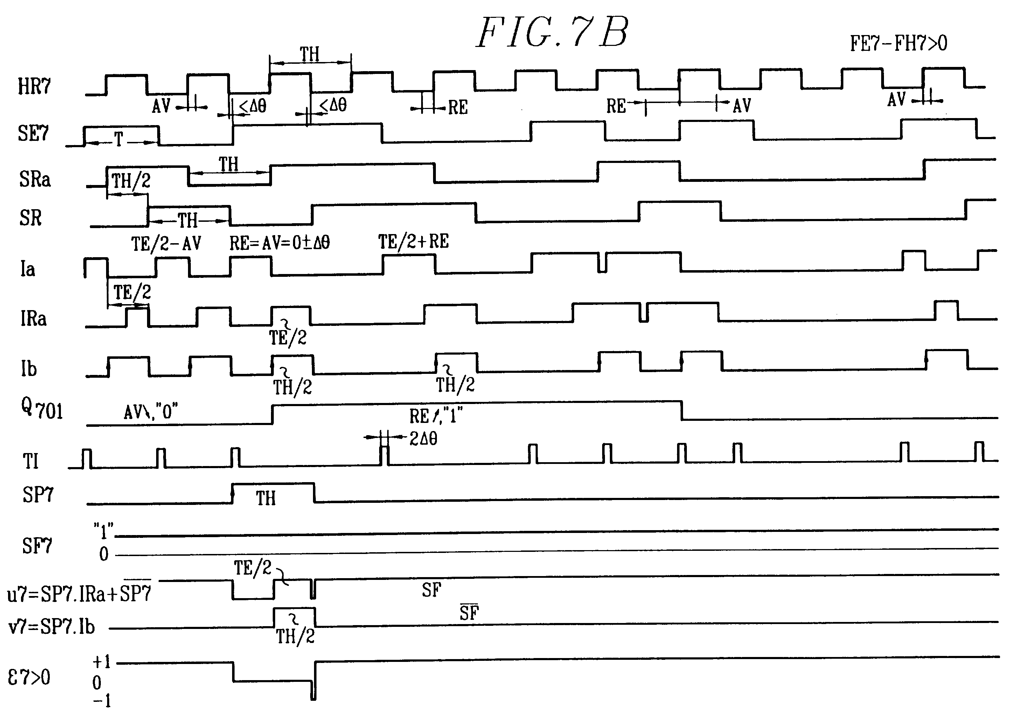

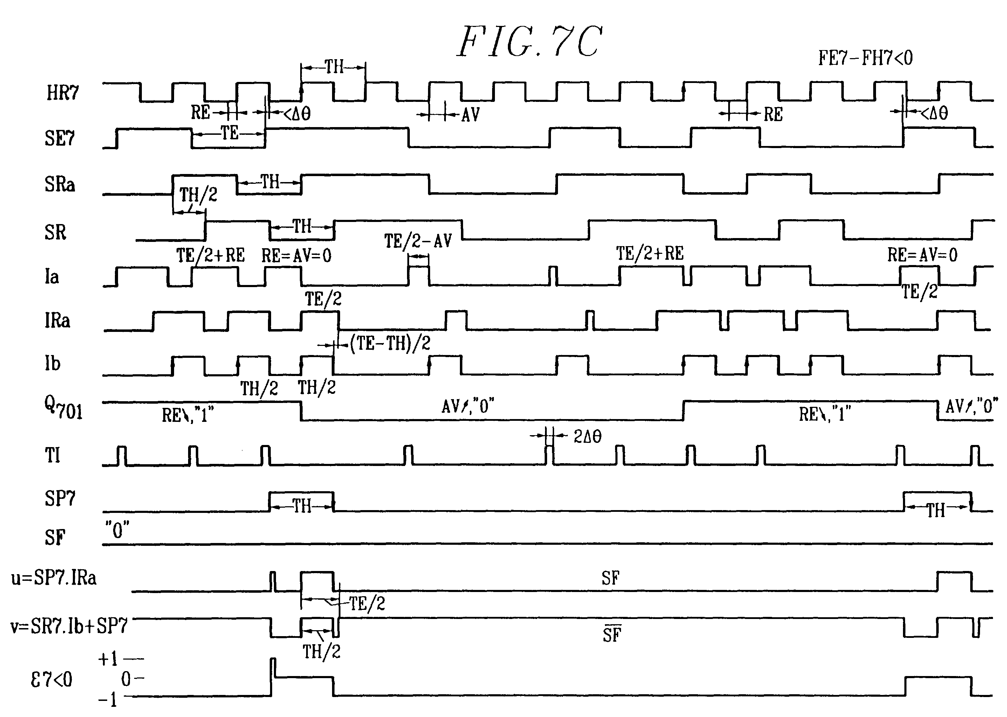

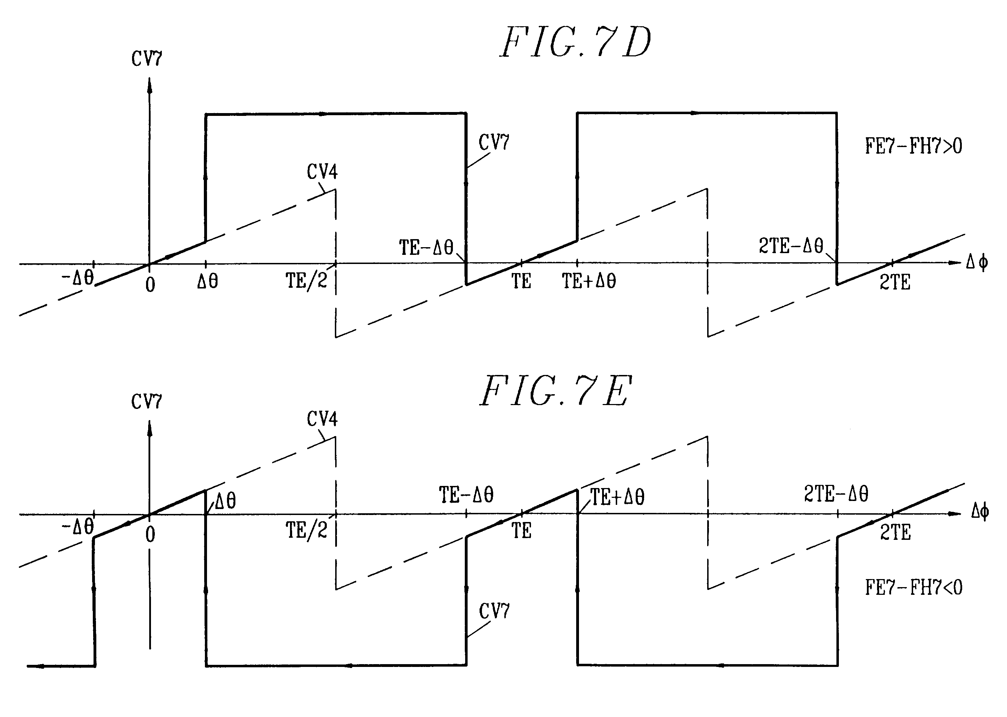

Un comparateur de phase CP4 dont le signal d'erreur ε4 indique l'amplitude de la différence de phase entre le signal d'horloge récupérée HR4 et le signal d'entrée SE4 additionnellement au signe de la différence entre ces deux signaux est décrit dans l'article de Charles. R. Hogge, Jr, intitulé "A Self Correcting Clock Recovery Circuit", paru dans Journal of Lightwave Technology, Vol. LT-3, N°6, pages 1312 - 1314, Decembre 1985 (également figure 7 dans EP-A-0 054 322).

Comme montré à la figure 4A, le comparateur de Hogge CP4 comprend deux bascules D en cascade 40a et 40b, deux portes OU-EXCLUSIF 41a et 41b, un amplificateur différentiel 42, une ligne à retard de TE/2 43 et un inverseur 44. L'entrée D de la bascule 40a reçoit le signal numérique d'entrée SE4. Le signal d'horloge récupérée HR4 sortant de l'oscillateur local VCO est appliqué directement et à travers l'inverseur 44 aux entrées d'horloge CL des bascules 40a et 40b respectivement. La sortie Q de la bascule 40b dont l'entrée D est reliée à la sortie Q de la bascule 40a, établit le signal régénéré SR4. Les deux entrées des portes OU-EXCLUSIF 41a et 41b sont respectivement reliées aux entrée D et sortie Q des bascules 40a et 40b. Les sorties des portes 41a et 41b sont respectivement reliées à travers la ligne à retard 43 et directement aux entrées directe et inverse de l'amplificateur différentiel 42. L'amplificateur différentiel 42 établit en sortie un signal d'erreur ε4 dont le niveau positif ou négatif représente la moyenne temporelle de la différence de phase entre le signal d'entrée et le signal d'horloge regénérée. Cette moyenne temporelle est obtenue par lissage du signal ε4 dans le filtre actif FP en un signal CV4 asservissant la phase de l'horloge récupérée HR4 à la phase du signal d'entrée SE4.

Selon une autre variante, la ligne à retard peut être placée entre l'entrée D de la bascule 40a et la première entrée de la porte 41a sans modifier fonctionnellement le comparateur CP4.

En référence à la figure 4B où le signal HR4 est supposé en avance par rapport au signal SE4 et où les périodes TH et TE sont égales, la première porte OU-EXCLUSIF 41a dans le comparateur CP4 génère des impulsions Ia dont les fronts montants sont synchrones avec ceux du signal d'entrée SE4, et dont la largeur est variable. Cette largeur est égale à (TE/2 - AV) lorsque le signal HR4 est en avance de AV. La seconde porte OU-EXCLUSIF 41b génère en sortie des impulsions Ib ayant une largeur constante égale à une demi-période binaire TE/2 du signal d'entrée SE4. Les fronts montants des impulsions Ib coïncident avec les fronts montants du signal d'horloge HR4 et donc avec les fronts descendants des impulsions Ia à la sortie de la première porte OU-EXCLUSIF. Les impulsions Ia sont retardées de la demi-période binaire TE/2 dans la ligne à retard 43 afin de former des impulsions IRa dont les fronts descendants coïncident avec ceux des impulsions Ib.

Dans ces conditions, le décalage temporel entre les fronts montants des impulsions Ia et Ib est précisément égal à la grandeur du déphasage AV entre les signaux SE4 et HR4. L'amplitude moyenne du signal d'erreur négatif ε4 pour commander l'oscillateur commandé en tension est alors directement proportionnelle à l'avance AV, comme montré à la dernière ligne de la figure 4B. L'avant-dernière ligne de la figure 4B montre le signal de différence ε4 = IRa - Ib dont les créneaux de largeur AV sont lissés sur une période plus grande que TE pour obtenir le signal de commande CV4.

Lorsque le signal HR4 est en retard de RE par rapport au signal SE4, comme montré à la figure 4C, les impulsions Ia et IRa ont une largeur égale à TE/2+RE, et le signal d'erreur ε4 produit par l'amplificateur différentiel 42 a une amplitude positive moyenne proportionnelle au retard RE.

Les différents comparateurs de phase qui viennent d'être présentés sont fréquemment utilisés pour une conception de boucle de verrouillage de phase. Néanmoins, lors d'une telle conception de boucle de phase, un problème fondamental est de garantir à la fois une plage d'acquisition en fréquence suffisamment large et une bande de bruit (oscillations instables) suffisamment faible au voisinage d'un état stable. La précision en fréquence des oscillateurs dans certaines applications nécessite une plage d'acquisition en fréquence qui n'est pas compatible avec les contraintes de gigue à l'état permanent autour d'un état stable de la boucle de phase. La méthodologie la plus courante pour la conception de la boucle consiste d'une part à choisir des paramètres de la boucle de manière à satisfaire les spécifications en gigue, la fonction de transfert de la boucle assurant alors une stabilité du signal d'horloge régénérée au voisinage d'un état stable, et d'autre part à utiliser une technique d'aide à l'acquisition pour augmenter la plage d'acquisition en fréquence. La technique la plus courante d'aide à l'acquisition, comme déjà signalé précédemment, est le balayage en fréquence. Celle-ci consiste à ajouter au signal sortant du filtre de boucle, un signal périodique ayant une amplitude suffisante pour balayer la fréquence de l'oscillateur. Toutefois, pour que cette acquisition en fréquence se produise, il est nécessaire que la vitesse de balayage soit faible, ce qui a pour inconvénient de ralentir la phase d'acquisition.

Pour expliquer de façon intuitive que l'augmentation de la plage d'acquisition en fréquence et la diminution du bruit de phase sont des contraintes antagonistes dans une boucle à verrouillage de phase, il faut concevoir qu'une grande plage d'acquisition nécessite l'utilisation d'une boucle telle que la fréquence d'horloge récupérée se stabilise à un état stable très rapidement en réponse par exemple à un saut de fréquence. Mais dans ce cas, pour des déphasages du signal d'entrée reçu autour de points stables définis par l'horloge récupérée, le comportement de la boucle de phase génère des bruits de phase par "manque d'inertie" autour de points stables. Les recalages de phase "brusques" provoquent en effet des bruits de phase détériorant la transmission.

Une autre technique d'aide à l'acquisition plus intéressante consiste à remplacer, selon l'invention, le comparateur de phase par un comparateur de phase/fréquence. Un comparateur de phase diffère d'un comparateur de phase/fréquence en ce que ce dernier élabore en "boucle ouverte" une tension continue ayant un même signe que l'écart de fréquence à compenser entre le signal d'horloge récupérée et le signal d'entrée reçu. Dès que la boucle est fermée, cette tension est appliquée à l'oscillateur commandé en tension et permet un verrouillage très rapide de la fréquence de l'oscillateur sur celle du signal d'entrée reçu.

Les comparateurs de phase/fréquence selon l'invention sont destinés à de la récupération de rythme d'un signal d'entrée numérique et autorisent de larges plages d'acquisition et de faibles bruits de phase au voisinage d'états stables.

Les comparateurs selon l'invention décrits ci-dessous mettent en oeuvre le principe suivant. Un comparateur de phase peut être transformé en un comparateur de phase/fréquence en ne validant la sortie dudit comparateur de phase que lorsque l'erreur de phase est comprise dans un intervalle prédéterminé centré autour d'un point stable, ce qui signifie que l'écart de phase entre le signal d'horloge récupérée et le signal d'entrée reçu est faible.

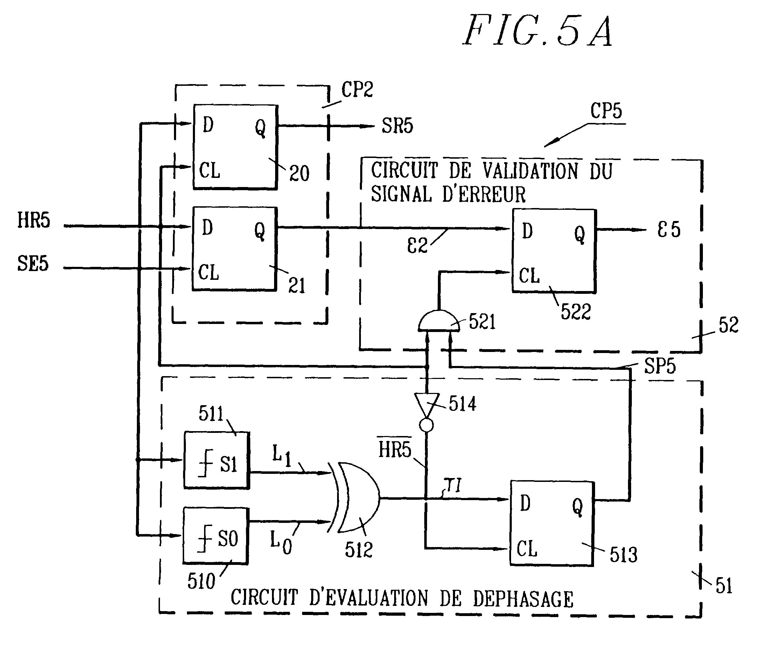

En référence à la figure 5A, un comparateur de phase/fréquence CP5 selon l'invention comprend le comparateur de phase connu CP2 du type signe incluant les bascules 20 et 21 et établissant le premier signal d'erreur ε2, ainsi qu'un circuit d'évaluation de déphasage 51 établissant un signal de détection de phase SP5, et un circuit de validation de signal d'erreur 52 modifiant le premier signal d'erreur ε2 en un second signal d'erreur ε5.

Le signal de détection de phase SP5 établi par le circuit 51 est appliqué au circuit 52. Le signal SP5 est à l'état "1" lorsque les fronts descendants du signal d'horloge récupérée HR5 coïncident avec un intervalle prédéterminé $2\Delta\Theta$ centré sur des fronts descendants et montants délimitant les éléments binaires du signal d'entrée SE5. Ceci signifie que le déphasage $\Delta\Phi$, dit également erreur de phase, entre le signal numérique d'entrée SE5 et le signal d'horloge récupérée HR5 est compris entre des limites prédéterminées $-\Delta\Theta$ et $+\Delta\Theta$, c'est-à-dire varie autour d'une phase d'équilibre stable.

En pratique, l'intervalle de phase $2\Delta\Theta$ est déterminé en fonction des temps de transition entre états logiques "0" et "1" dans le signal d'entrée SE5.

Le circuit 51 comprend des moyens de détection de transitions du signal d'entrée SE5 et des moyens pour produire un signal de détection de phase signalant la phase relative du signal d'horloge récupérée HR5 par rapport aux transitions, à $\pm\Delta\Theta$ près.

Les moyens de détection de transitions comprennent deux comparateurs à seuil 510 et 511 et une porte OU-EXCLUSIF 512. Les comparateurs 510 et 511 reçoivent le signal d'entrée SE5 qui, par ailleurs, est appliqué aux entrées D et CL des bascules 20 et 21 respectivement. Le signal SE5 est comparé à deux seuils de tension S0 et S1 dans les comparateurs 510 et 511 qui sont tels que :

$$VO < S0 < VM \text{ et } VM < S1 < V1$$

avec $VM = (VO + V1)/2 = (S0 + S1)/2$.

Dans les relations précédentes, comme montré à la figure 2B, VO et V1 dénotent des tensions de référence correspondant aux états logiques bas "O" et haut "1" dans le signal SE5, et VM la tension moyenne entre les tensions VO et V1. Les seuils S0 et S1 sont aussi symétriques par rapport à la tension moyenne VM. Lorsque la tension en entrée d'un comparateur à seuil 510, 511 est supérieure au seuil correspondant SO, S1, le signal logique L1, LO sortant du comparateur et appliqué à une entrée respective de la porte 512 est à l'état haut "1". Il en résulte que la sortie de la porte OU-EXCLUSIF 512 produit des impulsions TI en réponse à chaque front, montant ou descendant, dans le signal SE5. En moyenne, les impulsions de transition TI ont une largeur égale à $2\Delta\Theta$.

Les moyens pour produire un signal de détection de phase signalant la phase relative d'horloge récupérée dans le circuit 51 sont sous la forme d'une bascule de type D 513, et d'un inverseur 514. Le signal d'horloge récupérée HR5 est appliqué à l'entrée d'horloge CL de la bascule 513 à travers l'inverseur 514, ainsi qu'aux entrées CL et D des bascules 20 et 21. La sortie de la porte 512 est reliée à l'entrée D de la bascule 513. La sortie Q de la bascule 513 produit le signal de détection de phase SP5. Comme montré à la deuxième ligne de la figure 5B, lorsque le signal $\overline{HR}5$ complémentaire du signal d'horloge HR5 et produit par l'inverseur 514 présente des fronts montants compris dans la largeur $2\Delta\Theta$ des impulsions TI, le signal SP5 est à l'état "1".

Le circuit de validation de signal d'erreur 52 comprend une porte ET à deux entrées 521 et une bascule de type D 522. Les entrées de la porte 521 reçoivent respectivement les signaux HR5 et SP5. La sortie de la porte 521 est reliée à l'entrée d'horloge CL de la bascule 522 et reproduit au moins une période du signal d'horloge HR5 en réponse à l'état "1" du signal de détection de phase SP5. La sortie Q de la bascule 21 produisant le premier signal d'erreur ε2 sortant du comparateur de phase CP2 est reliée à l'entrée D de la bascule 522 dont la sortie Q produit le second signal d'erreur ε5.

Ainsi, lorsque le signal SP5 est à l'état "1", la porte 521 est ouverte, et la bascule 522 lit le signe du signal d'erreur ε2 en reproduisant celui-ci.

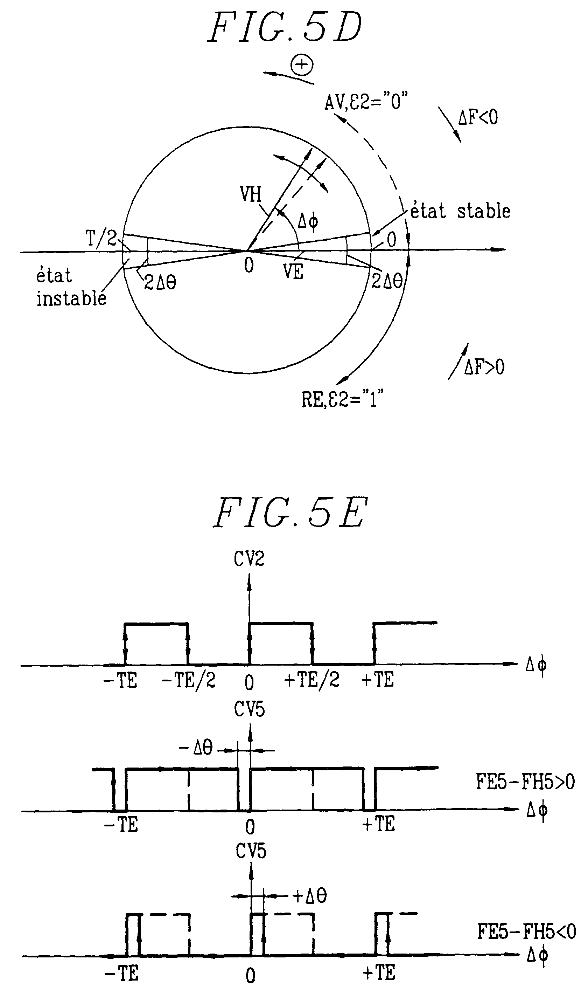

La figure 5D montre un diagramme de phase relatif au fonctionnement du comparateur CP5 selon l'invention. Dans ce diagramme, les signaux sont représentés sous forme vectorielle, et il est indiqué un déphasage relatif ΔΦ entre le signal d'entrée SE5 représenté par un vecteur fixe VE, et le signal d'horloge récupérée HR5 représenté par un vecteur VH tournant en fonction du temps. Plus précisément, la position du vecteur VE représente la phase du milieu d'une transition logique modulo 2Π du signal d'entrée SE5, et la position du vecteur VH représente la phase d'un front montant du signal d'horloge complémentaire $\overline{HR5}$. Le déphasage ΔΦ est donc représenté par un angle orienté entre le vecteur VE et le vecteur VH. Il est supposé par la suite qu'un écart de fréquence ΔF5 entre une fréquence FH5 du signal d'horloge récupérée HR5 et la fréquence FE5= 1/TE du signal d'entrée SE5 est très petit devant ladite fréquence FE5 du signal d'entrée. Néanmoins le comparateur CP5 fonctionne pour une large plage d'acquisition en fréquence comparativement à la technique antérieure. Dans la suite, des informations sont indiquées pour déterminer une limite supérieure d'un écart de fréquence ΔF5 afin de permettre un fonctionnement convenable d'un circuit de récupération de rythme incluant le comparateur CP5.

Comme montré à une troisième ligne de la figure 2B, on rappelle que le premier signal d'erreur ε2 est à l'état "O" lorsque le signal d'horloge HR5 est en avance AV par rapport au signal d'entrée SE5, ce qui se traduit par une rotation positive du vecteur VH suivant le sens contraire des aiguilles d'une montre, et à l'état "1" lorsque le signal HR5 est en retard RE par rapport au signal SE5, ce qui se traduit par une rotation négative du vecteur VH suivant le sens des aiguilles d'une montre.

La largeur 2ΔΘ des impulsions de transition TI produites à chaque transition du signal SE5 par les moyens de détection de transitions 510-511-512 est représenté par un angle 2ΔΘ sur le diagramme de phase. En effet, le vecteur VE correspond au milieu d'une transition du signal d'entrée à modulo 2Π près et donc une largeur d'impulsion peut être traduite par un angle sur le diagramme de phase. Lorsque le vecteur VH appartient à cet angle, le signal SP5 est alors à l'état "1".

Une telle représentation couramment utilisée pour les signaux analogiques est ici valable avec l'hypothèse que l'écart de fréquence ΔF5 est très petit devant la fréquence du signal d'entrée SE5.

Lorsque la fréquence FH5 du signal d'horloge récupérée HR5 est inférieure à la fréquence FE5 = 1/TE du signal d'entrée SE5 et tend vers la fréquence FE5, le vecteur d'horloge VH tourne dans le sens contraire des aiguilles d'une montre. Les fronts montants du signal d'horloge HR5 se déphasent à chaque période d'un écart de fréquence relatif de +(ΔF5/FE5)2Π par rapport au signal d'entrée SE5. Ainsi, au début d'une phase d'acquisition, par exemple, lorsque l'écart de fréquence ΔF5 est positif et le signal d'horloge récupérée HR5 présente initialement un retard de phase RE alors représenté par un déphasage négatif Δφ diminuant en module, le signal d'erreur ε2 est alors à l'état "1" et le vecteur VH tourne suivant le sens contraire des aiguilles d'une montre. Le signal de détection de phase SP5 est alors à l'état "O". Lorsque le vecteur tournant VH est positionné dans le premier demi-écart angulaire -ΔΘ, des fronts montants du signal d'horloge complémentaire $\overline{HR5}$ coïncident avec des impulsions de transition TI du signal SE5. Le signal de validation passe à l'état "1", la porte ET 521 est ouverte et le signal d'erreur ε2 est alors reproduit à la sortie Q de la bascule 522 précisément par le signal d'erreur ε5, à l'état "1".

Puis le vecteur tournant VH représentant la phase du signal d'horloge complémentaire $\overline{HR5}$ s'inscrit dans un deuxième demi-écart angulaire +ΔΘ, le signal d'erreur ε5 à la sortie du comparateur de phase CP2 passe alors à l'état "O", le signal de détection de phase SP5 est toujours à l'état "1", et la porte ET 521 est ouverte. En réponse à un front montant du signal d'horloge HR5 succédant au changement d'état du signal d'erreur ε2, le signal d'erreur ε5 passe à l'état "O" et est maintenu à cet état tant que le vecteur d'horloge tournant VH est inscrit dans l'écart angulaire [O,T-ΔΘ], c'est-à-dire jusqu'à un prochain passage du vecteur tournant VT dans le demi écart angulaire -ΔΘ.

Ainsi, pour un écart de fréquence positif, le second signal d'erreur ε5 est maintenu à l'état "0", excepté pour une largeur d'une demi-impulsion -ΔΘ, et cela à partir d'une transition du signal de détection de phase SP5 à l'état "1" correspondant à une coïncidence des fronts montants du signal d'horloge complémentaire $\overline{HR5}$ avec des impulsions TI.

Lorsque la fréquence FH5 du signal d'horloge récupérée est supérieure à la fréquence FE5 = 1/TE du signal d'entrée SE5 et tend vers la fréquence FE5, un résultat complémentaire du précédent et correspondant à un écart de fréquence négatif -(ΔF5/FE5)2Π conduit à ce que le signal d'erreur ε5 est maintenu à l'état "1" excepté pour une demi-largeur d'impulsion TI/2 correspondant à un déphasage +ΔΘ.

Le signal d'erreur "essentiellement" à l'état "O" et à l'état "1" respectivement pour des écarts de fréquence positif et négatif est appliqué à l'oscillateur commandé en tension VCO à travers le filtre FP pour asservir la fréquence FH5 de l'horloge récupérée HR5 à la fréquence FE5 du signal.

Pour un bon fonctionnement du comparateur CP5, il est nécessaire que le signal d'erreur ε5 soit "très rapidement" mis à l'état "1" ou "O" pour asservir convenablement l'oscillateur commandé en tension VCO à la fréquence du signal, c'est-à-dire lors d'un premier "passage" du vecteur tournant VH dans un demi-écart angulaire (+ΔΘ) ou (-ΔΘ), et donc nécessite des demi-écarts angulaires larges pour de larges acquisitions en fréquence. Mais également les largeurs d'impulsions TI doivent être les plus petites possibles pour permettre un bon fonctionnement de l'oscillateur commandé en tension VCO. Un compromis dans le choix de la largeur des impulsions TI doit donc être établi.

En pratique, des "largeurs" d'acquisition en fréquence environ dix fois supérieures à celles de la technique antérieure sont obtenues.

La première ligne de la figure 5E montre la caractéristique du signal d'erreur ε2 obtenu à la sortie du comparateur de phase CP2 pour un écart de fréquence positif et négatif entre le signal d'horloge récupérée HR2 et le signal d'entrée SE2. L'axe des abscisses désigne le déphasage ΔΦ entre le signal d'horloge HR2 et le signal d'entrée SE2. Cette caractéristique est interprétée de la manière suivante :

-   dans le cas d'un écart de fréquence positif, le signal d'erreur ε2 est obtenu en "suivant" la caractéristique de la droite vers la gauche en fonction du déphasage ΔΦ évoluant au cours du temps;
-   dans le cas d'un écart de fréquence négatif, on "suit la caractéristique" de la gauche vers la droite.

Les seconde et troisième lignes de la figure 5E montrent respectivement les caractéristiques du signal d'erreur ε5 obtenues pour un écart de fréquence positif et pour un écart de fréquence négatif. En d'autres termes, l'oscillateur commandé en tension VCO reçoit un signal de commande CV5 à travers le filtre FP pour asservir convenablement la fréquence de l'horloge récupérée HR5 à la fréquence du signal d'entrée SE5. Le signal CV5 dépend du signal d'erreur ε5 à la sortie du comparateur CP5 qui peut être à l'état "1" ou "0" pour un écart de fréquence positif et un écart de fréquence négatif.

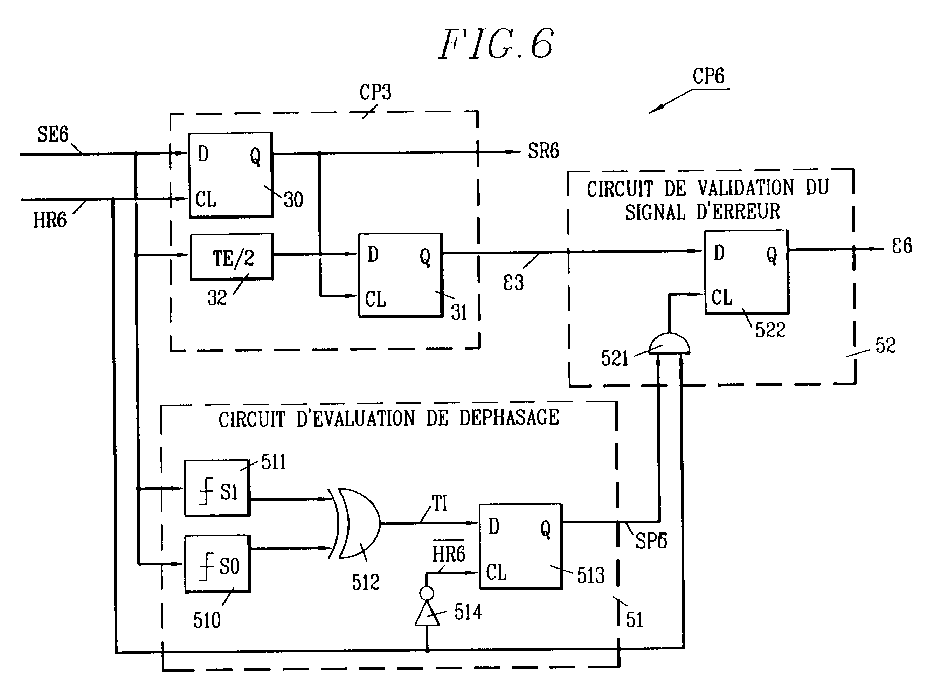

En variante, un autre comparateur de phase/fréquence de type signe CP6 comprend le comparateur CP3 montré à la figure 3, le circuit d'évaluation de déphasage 51, et le circuit de détection de phase 52, comme montré à la figure 6. Les circuits 51 et 52 sont agencés de la même manière que dans la figure 5. Le signal numérique d'entrée SE6 est appliqué à l'entrée D de la bascule 30, à l'entrée de la ligne à retard 32 et aux entrées des comparateurs à seuil 510 et 511. Le signal d'horloge récupérée HR6 est appliqué à l'entrée d'horloge CL de la bascule 30, à l'inverseur 514 et à une entrée de la porte ET 521. La sortie Q de la bascule 30 fournit un signal régénéré SR6. La sortie Q de la bascule 31 fournit le signal d'erreur ε3 et est reliée à l'entrée D de la bascule 522. La sortie Q de la bascule 522 délivre un signal d'erreur ε6 sortant du comparateur CP6. Les mêmes caractéristiques que celles montrées dans la figure 5E sont obtenues pour le signal de commande en fonction d'un écart de fréquence positif ou négatif ΔF6.

Des comparateurs de phase/fréquence selon l'invention incluant un comparateur de phase linéaire, dit comparateur de Hogge, sont maintenant décrits.

En référence à la figure 7A, un premier comparateur de phase/fréquence CP7 comprend deux bascules 740a et 740b, deux portes OU-EXCLUSIF 741a et 741b et une ligne à retard 743 agencés comme les éléments 40a, 40b, 41a et 41b, et 43 dans le comparateur de phase linéaire CP4. Le comparateur CP7 comporte également un circuit d'évaluation de déphasage 751 dans lequel les éléments 510 à 514 du circuit d'évaluation 51 de la figure 5A sont retrouvés. Le signal numérique d'entrée SE7 est ainsi appliqué à une entrée de la porte 741a, à l'entrée D de la bascule 740a et aux entrées des comparateurs à seuil 510 et 511 dans le circuit 751, et le signal d'horloge récupérée HR7 est appliqué à l'entrée CL de la bascule 740a et, à travers l'inverseur 514 qui fait également office d'inverseur 44 (figure 4A), aux entrées CL des bascules 740b et 513.

Le comparateur CP7 comprend également un circuit de détection de signe d'écart de fréquence 70, un circuit logique 703 et un amplificateur différentiel 742 produisant un second signal d'erreur ε7. Le circuit de détection 70 comprend deux bascules 701 et 702 en cascade. Les entrées D et CL de la bascule 701 reçoivent respectivement le signal IRa issu de la ligne à retard 743, et le signal Ib issu de la porte 741b, les signaux IRa et Ib étant représentatif du premier signal d'erreur ε4. La sortie Q de la première bascule 701 est reliée à l'entrée D de la seconde bascule 702 et produit un signal d'avance/retard $Q_{701}$ dont les états sont représentatifs de l'avance (AV) et du retard (RE) du signal d'horloge HR7 par rapport au signal d'entrée. L'entrée d'horloge CL de la bascule 702 reçoit un signal de détection phase SP7 issu de la bascule 513, identique au signal SP5 établi par le circuit 51, à travers un inverseur 704. La sortie Q de la bascule 702 produit un signal de signe d'écart de fréquence SF qui est fonction du sens des transitions logiques détectées dans le signal d'avance/retard $Q_{701}$ lorsque le signal SP7 est à l'état "1". Le circuit logique 703 du type réseau logique programmable (PLA) reçoit les signaux IRa et Ib à deux premières entrées, et le signal de signe d'écart de fréquence SF et le signal de phase SP7 à deux secondes entrées afin de produire à des sorties respectives des signaux logiques u7 et v7 tels que :

$$u7 = SP7.IRa + \overline{SP7}. SF$$

$$v7 = SP7.Ib + \overline{SP7}. \overline{SF}.$$

Les signaux u7 et v7 sont respectivement appliqués à l'entrée directe et à l'entrée inverse de l'amplificateur différentiel 742 équivalent à l'amplificateur 42 dans le comparateur de phase CP4 (figure 4A).

Le fonctionnement du comparateur CP7 est maintenant plus précisément décrit en référence aux figures 7B, 7C, 7D et 7E.

Comme déjà signalé, le signal de détection de phase SP7 est identique au signal de détection de phase SP5 de la figure 5A. Le signal SP7 passe à un état haut "1" lorsqu'un front montant du signal complémentaire

$\bar{HR7}$ coïncide avec une impulsion TI, c'est-à-dire au voisinage $2\Delta\Theta$ d'un état stable pour lequel les signaux HR7 et SE7 sont considérés en phase.

Les diagrammes temporels des figures 7B et 7C concernent respectivement un signal d'horloge HR7 ayant une fréquence FH7 inférieure à celle FE7 du signal d'entrée SE7, soit un écart de fréquence $\Delta F7 = FE7 - FH7 > 0$, et un signal d'horloge HR7 ayant une fréquence FH7 supérieure à celle FE7 du signal d'entrée SE7, soit un écart de fréquence $\Delta F7 = FE7 - FH7 < 0$. Le signal $Q_{701}$ à la sortie de la bascule 701 est cycliquement à l'état "O" lorsque le signal d'horloge est en avance de phase AV, et à l'état "1" lorsque le signal d'horloge est en retard de phase RE.

En référence au diagramme de phase de la figure 5D en combinaison avec la figure 7B, pour un écart de fréquence $\Delta F7$ positif, puisque le vecteur tournant VH représente la phase d'un front montant du signal complémentaire $\bar{HR7}$ variant en fonction du temps, le vecteur VH évolue dans le sens contraire des aiguilles d'une montre pour passer d'une avance de phase à un retard de phase cycliquement. En d'autres termes, l'avance de phase diminue et le retard de phase augmente de part et d'autre d'un déphasage quasi-nul à $\pm\Delta\Theta$ près, signalé par un front montant du signal d'avance/retard $Q_{701}$ en sortie de la bascule 701. Le front montant du signal $Q_{701}$ est inscrit dans un créneau du signal de phase SP7 signalant une "mise en phase" momentanée. La seconde bascule 702 dans le circuit 70 lit l'état du signal $Q_{701}$ après le passage de mise en phase de manière, grâce au signal complémentaire $\bar{SP7}$, à produire à sa sortie Q un signal SF à l'état "1" qui traduit le signe positif de l'écart de fréquence FE5-FH5.

Le circuit logique 703 vise à sélectionner des impulsions IRa et Ib pendant au moins une période d'horloge TH déterminée par un créneau du signal de phase SP, ces impulsions ayant des largeurs différentes respectivement égales à la demi-période $TE/2 = 1/(2.FE7)$ du signal d'entrée à $\pm\Delta\Theta$ près et à la demi-période $TH/2 = 1/(2.FH7)$ du signal d'horloge récupéré. Le circuit logique 703 reçoit d'une part les signaux d'impulsion IRa et Ib et d'autre part les signaux SF et SP7 pour produire deux signaux logiques u7 et v7 parallèles tels que

$$u7 = SP7.IRa + \bar{SP7}. SF$$

$$v7 = SP7.Ib + \bar{SP7}. \bar{SF}$$

et dans le cas présent, pour $\Delta F7 > 0$, soit SF = "1", tels que :

$$u7 = SP7.IRa + \bar{SP7}$$

$$v7 = SP7.Ib .$$

Le premier signal u7 reproduit une impulsion de largeur TE/2 et le second signal v7 reproduit une impulsion de largeur TH/2 pendant la durée d'un créneau du signal de signe SP7. Les signaux u7 et v7 sont appliqués respectivement aux entrées directe et inverse de l'amplificateur différentiel 742 qui produit un signal d'erreur $\varepsilon7$ dont l'amplitude est fonction de la différence des largeurs (TH-TE)/2 des impulsions et est en moyenne positive.

D'une manière analogue, en référence aux figures 5D et 7C, pour un écart de fréquence $\Delta F7$ négatif, le signal de signe d'écart de fréquence SF est à l'état "0" et résulte d'un passage d'un retard de phase RE diminuant, signalé par un état "1" du signal $Q_{701}$, à une avance de phase augmentant AV, signalée par un état "0" du signal $Q_{701}$. En effet, dans ce cas le vecteur tournant VH "tourne" dans le sens inverse des aiguilles d'une montre, les fronts montants du signal de phase SP7 coïncident alors avec un retard de phase et les fronts descendants coïncident avec une avance de phase. Le signal $Q_{701}$ est alors échantillonné à l'état "O". Les signaux u7 et v7 issus du circuit logique 703 sont

$$u7 = SP7.IRa$$

$$v7 = SP7.Ib + \bar{SP7}.$$

Le signal d'erreur $\varepsilon7$ a alors une amplitude moyenne négative qui est fonction de l'écart de fréquence négatif $\Delta F7$.

Les caractérisques du signal d'erreur $\varepsilon7$ en fonction du déphasage $\Delta\Phi$ sont montrées à la figure 7D et 7E respectivement pour un écart de fréquence positif et pour un écart de fréquence négatif.

La courbe en dents de scie dessinée en traits interrompus courts dans les figures 7D et 7E traduit le signal d'erreur $\varepsilon4$ du comparateur de Hogge ou plus précisément la moyenne temporelle CV4 du signal $\varepsilon4$ pour un écart de fréquence donné dans le comparateur de Hogge CP4. En effet, pour un écart de fréquence $\Delta F4$ nul entre l'horloge récupérée HR4 et le signal d'entrée SE4 dans le comparateur de Hogge CP4 montré à la figure 4A, les impulsions dans le signal $\varepsilon4$ montrées aux figures 4B et 4C sont respectivement négatives et positives, et les moyennes temporelles associées CV4 pour asservir la phase de l'oscillateur VCO à la phase du signal d'entrée sont respectivement fonction de la largeur de ces impulsions dont la largeur maximale est égale à TE/2. Ainsi, lorsque l'écart fréquence $\Delta F4$ est différent de zéro, on passe d'une avance à un retard de phase avec des impulsions de signal $\varepsilon4$ dont la largeur varie. La moyenne temporelle associée décrit alors une droite entre un retard de phase maximum (-TE/2) et une avance de phase maximum (+TE/2).

Dans le cas d'un écart de fréquence $\Delta F7$ positif dans le comparateur phase/fréquence CP7 selon l'invention, les signaux u et v appliqués à l'amplificateur différentiel 742 sont tels que :

$$u7 = SP7.IRa + \bar{SP7}$$

$$v7 = SP7. Ib$$

et donc des impulsions IRa et Ib sont "validées" dans le circuit logique 703 lorsque le signal de phase SP est à l'état "1", c'est-à-dire au voisinage $\pm\Delta\Theta$ d'un état stable de déphasage nul. Au dehors du voisinage $\pm\Delta\Theta$ d'un état stable, le signal SP7 est à l'état "O" et donc les signaux u7 et v7 appliqués aux entrées de l'amplificateur différentiel 742 sont tels que u7 = $\overline{S}\overline{P}7$. SF = "1" et v7 = $\overline{S}\overline{P}7$.$\overline{S}\overline{F}$ = "0", ce qui impose une amplitude maximum positive au signal d'erreur $\varepsilon$7 et à sa moyenne temporelle CV7 commandant l'oscillateur VC0, proportionnelle à u7-v7 = "1".

Ainsi, pour un écart de phase $\pm\Delta\Theta$ centré autour des états stables, la caractéristique du comparateur CP7 est identique à la caractéristique du comparateur de Hogge CP4 représenté par des segments de droite tel que montré à la figure 7D dans les intervalles [N.TE-$\Delta\Theta$, N.TE + $\Delta\Theta$], où N est un entier positif ou négatif. A l'extérieur des écarts de phase $\pm\Delta\Theta$ centrés autour des états stables, on obtient un niveau d'amplitude en sortie de l'amplificateur 742 pour une application de u7= "1" et v7="0".

Des résultats analogues sont également obtenus pour un écart de fréquence $\Delta$F7=FE7-FH7 négatif, comme montré aux figures 7B et 7E. Au voisinage $\pm\Delta\Theta$ d'un état de phase stable, dans des intervalles [N.TE-$\Delta\Theta$, N.TE + $\Delta\Theta$], la caractéristique du comparateur CP7 varie linéairement en fonction du déphasage comme celle du comparateur de Hogge CP4. A l'extérieur de ces intervalles, les signaux u7 et v7 sont tels que u7=0 et v7=1 ce qui impose une amplitude de maximum négative au signal d'erreur $\varepsilon$7 et à sa moyenne temporelle CV7.

Les figures 7B à 7D montrent clairement que la sortie de l'amplificateur différentiel 742 asservit convenablement la fréquence de l'horloge récupérée HR7 grâce à un signal de tension à amplitude (polarité) tantôt positive, tantôt négative, appliqué à l'oscillateur commandé en tension VCO à travers le filtre actif FP.

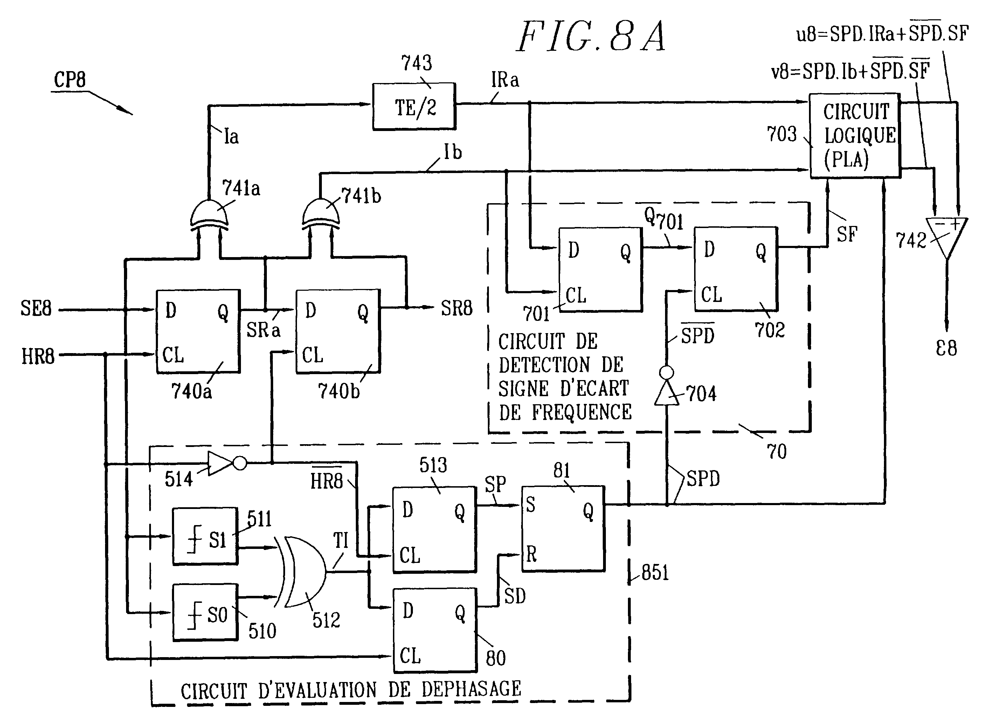

Le comparateur de phase/fréquence CP8 présenté à la figure 8A est une variante du comparateur CP7.

Le comparateur de phase/fréquence CP8 comprend deux bascules 740a et 740b, deux portes OU EXCLUSIF 741a et 741b, une ligne à retard de TE/2 743, un circuit de détection de signe d'écart de fréquence 70, un circuit logique 703, un inverseur 704, et un amplificateur différentiel 742 identiques à ceux inclus dans le comparateur CP7 et reliés de la même manière.

Le comparateur CP8 comprend également un circuit d'évaluation de déphasage 851 comprenant les deux comparateurs à seuil 510 et 511, la porte OU-EXCLUSIF 512, la bascule de type D 513 et l'inverseur 514 identiques à ceux inclus dans le circuit 751 et reliés de la même manière.

Le circuit 851 comprend en plus une bascule 80 de type D et une bascule 81 du type RS. L'entrée D de la bascule 80, comme celle de la bascule 513, est reliée à la sortie de la porte OU-EXCLUSIF 512. L'entrée d'horloge CL de la bascule 80 reçoit directement, comme la bascule 740a, le signal d'horloge récupérée HR8 qui est également appliqué aux entrées d'horloge des bascules 740b et 513 à travers l'inverseur 514. Les sorties Q des bascules 513 et 80 sont reliées aux entrées S et R de la bascule 81 et produisent un signal de phase SP et un signal de déphasage SD respectivement. La sortie Q de la bascule 81 applique un signal de phase-déphasage SPD à l'entrée d'horloge CL de la seconde bascule 702 dans le circuit de détection de signe d'écart de fréquence 70 à travers l'inverseur 704. Les sorties Q des bascules 81 et 702 sont reliées aux secondes entrées du circuit logique 703.

Ainsi le circuit logique 703 reçoit sur les deux premières entrées les signaux IRa et Ib respectivement issus de la ligne à retard 743 et de la porte OU-EXCLUSIF 741b, et sur les deux secondes entrées le signal SPD issu de la bascule RS et le signal SF issu de la sortie du circuit de détection de signe d'écart de fréquence 70, et applique deux signaux de sorties u8 et v8 aux entrées directe et inverse de l'amplificateur différentiel 742 respectivement.

Le fonctionnement du comparateur CP8 est maintenant décrit essentiellement au regard de la fonctionnalité supplémentaire introduite par les bascules 80 et 81 par rapport au comparateur CP7.

Il est rappelé que le signal de phase SP issu de la bascule 513 comporte des impulsions de phase à l'état "1" ayant une longueur TH lorsque des fronts descendants du signal d'horloge recupérée HR8 coïncident avec des impulsions TI à la sortie de la porte OU-EXCLUSIF 512, c'est-à-dire au voisinage d'un état stable, lorsque le déphasage $\Delta\Phi$ quasi-nul entre l'horloge recupérée HR8 et le signal d'entrée SE8 est inférieur à une largeur 2$\Delta\Theta$ d'impulsion TI. De même, le signal de déphasage SD à la sortie Q de la bascule 80 comporte des impulsions d'opposition de phase à l'état "1" pendant une durée TH lorsque des fronts montants du signal d'horloge récupérée HR8 coïncident avec des impulsions TI, c'est-à-dire au voisinage d'un état instable $\Delta\Phi = \Pi$ lorsque les fronts montants du signal d'horloge recupérée HR8 coïncïdent avec des impulsions de largeur 2$\Delta\Theta$ et donc avec les fronts montants du signal d'entrée SE8 à $\pm\Delta\Theta$ près. Le signal SDP à la sortie Q de la bascule 81 saute alors à l'état "1" en réponse à un état stable et donc à un déphasage sensiblement égal à O traduit par SP = "1" et à l'état "0" en réponse à un état instable et donc à un déphasage sensiblement égal à $\Pi$ traduit par SD = "1". Le signal de signe d'écart SF en sortie de la bascule 702 demeure inchangé.

Le circuit logique 703 dans le comparateur CP8 effectue les mêmes opérations que dans le comparateur CP7 et établit deux signaux u8 et v8 qui sont tels que,

pour un écart positif de fréquence FE8-FH8 > 0 signalé par SF = "1" :

$$u8 = SDP.IRa + \overline{S}\overline{D}\overline{P}$$

$$v8 = SDP.Ib,$$

et pour un écart négatif de fréquence FE8-FH8 < 0 signalé par SF = "0" :

$$u8 = SDP.IRa$$

$$v8 = SDP.Ib + \bar{S}\bar{D}\bar{P}.$$

Pendant un intervalle périodique de retard déphasé [NTE-$\Delta\Theta$, (2N + 1)TE/2 - $\Delta\Theta$] pour SF = "1", le signal SDP est à l'état "1", et par suite, le signal u8 reproduit les impulsions IRa et le signal v8 reproduit les impulsions Ib. La différence de signaux u8 - v8 est effectuée par l'amplificateur différentiel pour produire un signal d'erreur $\varepsilon8$ dont l'amplitude varie pour chaque cycle de phase de TE en fonction de la différence de largeurs entre plusieurs impulsions successives IRa et Ib, au lieu de la différence des largeurs entre une impulsion IRa et Ib dans le comparateur CP7. Le signal d'erreur $\varepsilon8$ est donc plus précis que le signal $\varepsilon7$, et en particulier dépend moins d'absence de transitions dans le signal d'entrée lorsque celui-ci est composé de séquences de bits consécutifs au même état logique "1" ou "0".

Un résultat analogue est obtenu pendant des intervalles périodiques d'avance de phase [(2N-1)TE/2 + $\Delta\Theta$, N.TE + $\Delta\Theta$] pour SF = "0" correspondant à des écarts de fréquence négatif.

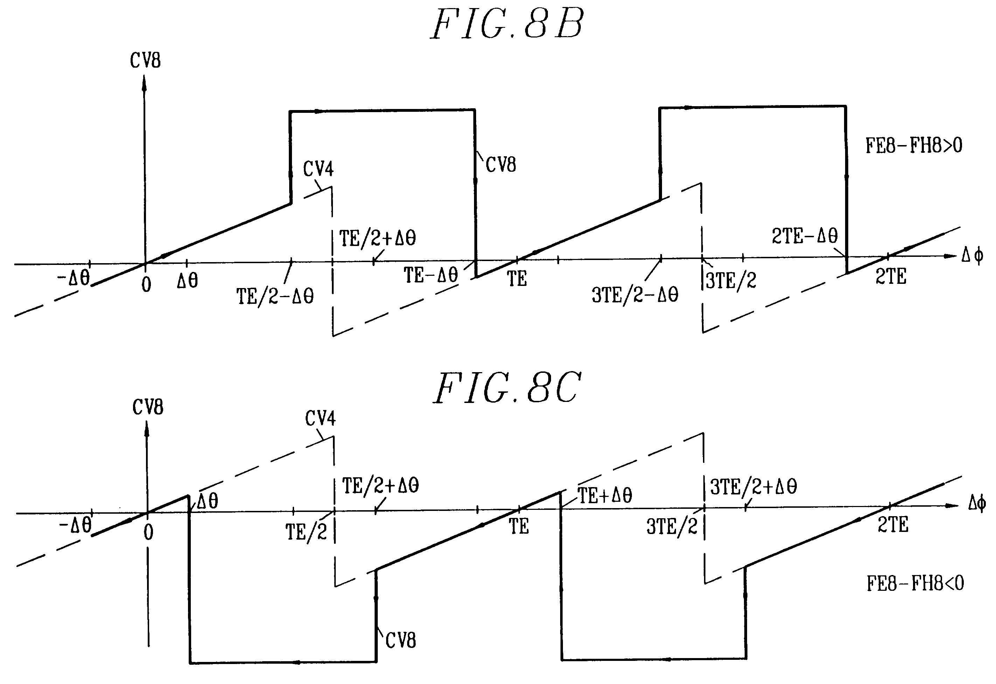

Ainsi en référence aux figures 8B et 8C, il apparaît que la moyenne temporelle CV8 du signal d'erreur $\varepsilon8$ présente les caractéristiques de celle relative au comparateur de Hogge CP4 seulement au voisinage $\pm\Delta\Theta$ d'un état stable, et varie également linéairement en croissant entre des déphasages [NTE + $\Delta\Theta$, (2N + 1) TE/2 - $\Delta\Theta$] lorsque le vecteur d'horloge VH tourne dans le sens contraire des aiguilles d'une montre correspondant à un écart de fréquence positif, et en décroissant entre des déphasages [NTE - $\Delta\Theta$, (2N - 1) TE/2-$\Delta\Theta$] lorsque le vecteur VH tourne dans le sens des aiguilles d'une montre correspondant à un écart de fréquence négatif.

Comme déjà dit, le comparateur de phase/fréquence CP8 établit un signal d'erreur dont le signe et l'amplitude varie statistiquement sensiblement une demi-période de déphasage TE/2 sur deux après le passage du signal d'horloge récupérée en phase avec le signal d'entrée. Cette propriété autorise la modification du signal d'erreur même lorsque le signal d'entrée SE8 n'offre pas de transition au voisinage de l'état stable de phase. D'une manière plus générale, le circuit d'évaluation de déphasage détecte, selon d'autres variantes, plusieurs déphasages prédéterminés entre le signal d'horloge et le signal d'entrée pendant plusieurs périodes d'horloge respective.

Cette propriété peut être également reportée dans les comparateurs de phase/fréquence CP5 et CP6 afin de produire des créneaux dans le signal de phase SP5, SP6 qui sont plus longs qu'une période TH du signal d'horloge régénérée, par exemple égales à deux ou trois périodes successives TH de manière à modifier le signal d'erreur $\varepsilon5$, $\varepsilon6$, respectivement à ajouter des impulsions de largeurs TE/2 et TH/2 dans les signaux u7 et v7, en réponse à des transitions du signal d'entrée au voisinage de l'état stable. Dans ce cas, le circuit 51 peut être remplacé par le circuit 851.

Il est à noter que les réalisations décrites en détail ci-dessus sont données à titre d'exemple et que d'autres variantes entrant dans le cadre de l'objet de la demande de brevet défini ci-après peuvent être conçues par l'homme du métier. En particulier, d'autres combinaisons d'éléments logiques, tels que portes et bascules ainsi que lignes à retard conférant des retards proportionnels à des multiples d'une valeur nominale de $\Delta\Theta$, peuvent être utilisés pour obtenir des résultats analogues aux comparateurs de phase/fréquence détaillés ci-dessus.

## Revendications

1.  Comparateur de phase/fréquence (CP5;CP7) comprenant des moyens de comparaison de phase (CP2; CP4) comparant les phases d'un signal numérique d'entrée (SE5;SE7) ayant une période binaire prédéterminée (TE) et d'un signal d'horloge (HR5;HR7) ayant une période d'horloge (TH) variable à un intervalle de temps prédéterminé (2$\Delta\Theta$) près par rapport à ladite période binaire afin de produire un premier signal d'erreur ($\varepsilon2$;$\varepsilon4$) dont le signe est fonction du signe de la différence de phase entre le signal d'entrée et le signal d'horloge, caractérisé en ce qu'il comprend des moyens d'évaluation de déphasage (51;751) pour détecter un déphasage prédéterminé ($\Delta\Phi$) entre le signal d'horloge (HR5; HR7) et le signal d'entrée (SE5;SE7) à l'intervalle de temps prédéterminé (2$\Delta\Theta$) près pendant une période d'horloge (TH) afin de produire un signal de détection de phase (SP5;SP7), et des moyens (52; 70,703) pour modifier le premier signal d'erreur en un second signal d'erreur ($\varepsilon5$,$\varepsilon7$) dont le signe est fonction du signe de la différence entre la période binaire (TE) et la période d'horloge (TH), en réponse au signal de détection de phase (SP5;SP7).

2.  Comparateur de phase/fréquence (CP5;CP7) conforme à la revendication 1, caractérisé en ce que le déphasage prédéterminé ($\Delta\Phi$) est sensiblement égal à zéro à l'intervalle de temps prédéterminé (2$\Delta\Theta$) près.

3.  Comparateur de phase/fréquence (CP5;CP7) conforme à la revendication 1, caractérisé en ce que les moyens d'évaluation de phase (51, 751) comprennent des moyens (510,511,512) pour détecter des transitions entre états logiques dans le signal d'entrée (SE5;SE7) afin de produire des impulsions de transition (TI) ayant une largeur sensiblement égale à l'intervalle de temps prédéterminé (2$\Delta\Theta$), et des moyens (513) pour produire une impulsion du signal de détection de phase (SP5;SP7) ayant une largeur au moins égale à une période d'horloge (TH) en réponse à une impulsion de transition (TI) sensiblement en phase avec un signal d'horloge ($\overline{HR}\overline{5}$; $\overline{HR}\overline{7}$) complémentaire dudit signal d'horloge.

4. Comparateur de phase/fréquence (CP8) conforme à la revendication 2, caractérisé en ce que les moyens d'évaluation de phase détectent plusieurs déphasages prédéterminés ($\Delta\Phi = \pm\Delta\Theta$; $\Delta\Phi = TE/2 \pm\Delta\Theta$) entre le signal d'horloge (HR8) et le signal d'entrée (HE8) pendant plusieurs périodes d'horloge respectives (TH).

5. Comparateur de phase/fréquence (CP8) conforme à la revendication 4, caractérisé en ce que les déphasages prédéterminés sont sensiblement égaux à 0 et $\Pi$ à l'intervalle de temps prédéterminé ($2\Delta\Theta$) près.

6. Comparateur de phase/fréquence (CP8) conforme à la revendication 4 ou 5, caractérisé en ce que les moyens d'évaluation de phase (851) comprennent des moyens (510,511,512) pour détecter des transitions entre états logiques dans le signal d'entrée (SE8) afin de produire des impulsions de transition (TI) ayant une largeur sensiblement égale à l'intervalle de temps prédéterminé ($2\Delta\Theta$), des moyens (513) pour produire une impulsion de phase (SP) ayant une largeur au moins égale à une période d'horloge (TH) en réponse à une impulsion de transition (TI) sensiblement en phase avec un signal d'horloge ($\overline{HR}\overline{8}$) complémentaire dudit signal d'horloge (HR8), des moyens (80) pour produire une impulsion d'opposition de phase (SD) ayant une largeur au moins égale à une période d'horloge (TH) en réponse à une impulsion de transition (TI) sensiblement en phase avec ledit signal d'horloge (HR7), et des moyens (81) pour produire une impulsion du signal de détection de phase (SDP) sensiblement entre l'impulsion de phase (SP) et l'impulsion d'opposition de phase (SD).

7. Comparateur de phase/fréquence (CP5), conforme à l'une quelconque des revendications 1 à 6, caractérisé en ce que les moyens pour modifier (52) comprennent des moyens (521) pour reproduire au moins une période ($CL_{522}$) du signal d'horloge (HR5) en réponse au signal de détection de phase (SP5), et des moyens (522) pour lire le signe du premier signal d'erreur ($\varepsilon 2$) en réponse à la période de signal d'horloge reproduite afin d'établir le second signal d'erreur ($\varepsilon 5$).

8. Comparateur de phase/fréquence (CP5) conforme à la revendication 7 dans lequel les moyens de comparaison de phase (CP2) comprennent une bascule (21) ayant une entrée de données recevant le signal d'horloge (HR5), une entrée d'horloge recevant le signal d'horloge (SE5), et une sortie transmettant le premier signal d'erreur ($\varepsilon 2$).

9. Comparateur de phase/fréquence (CP6) conforme à la revendication 7 dans lequel les moyens de comparaison de phase (CP3) comprennent une première bascule (30) ayant une entrée de données recevant le signal d'entrée (SE6) et une entrée d'horloge recevant le signal d'horloge (HR6), et une seconde bascule (31) ayant une entrée de données recevant le signal d'entrée (SE6) à travers une ligne à retard (32) conférant un retard d'une demi-période binaire (TE/2), une entrée d'horloge reliée à une sortie de la première bascule (30), et une sortie transmettant le premier signal d'erreur ($\varepsilon 3$).

10. Comparateur de phase/fréquence (CP7;CP8) conforme à l'une quelconque des revendications 1 à 6, caractérisé en ce que le second signal d'erreur ($\varepsilon 7$; $\varepsilon 8$) a une amplitude variant en signe et grandeur en fonction de la différence entre la période d'horloge variable (TH) et la période binaire (TE).

11. Comparateur de phase/fréquence (CP7;CP8) conforme à l'une quelconque des revendications 1 à 6 et 10, caractérisé en ce que

les moyens de comparaison de phase comprennent des moyens (740a,741a,743) pour établir des premières impulsions (IRa) ayant des largeurs qui varient en fonction du déphasage (AV,RE) entre le signal d'horloge (HR7;HR8) et le signal d'entrée (SE7;SE8), des moyens (740b,741b) pour établir des secondes impulsions (Ib) ayant des largeurs (TH/2) proportionnelles à la période d'horloge, et un moyen d'amplification différentielle (742), et en ce que les moyens pour modifier comprennent des moyens (70) pour comparer les largeurs de première et seconde impulsions en réponse au signal de détection de phase (SP; SPD) afin de produire un signal de signe logique (SF) dont les états sont représentatifs du signe de la différence entre la période binaire (TE) et la période d'horloge (TH), et des moyens (703) pour sélectionner des première et seconde impulsions pendant au moins une période d'horloge (TH) déterminée par le signal de détection de phase de manière à produire des premier et second signaux (u7,v7;u8,v8) reproduisant respectivement les première et seconde impulsions sélectionnées contenues dans la période d'horloge déterminée et l'état du signal de signe (SF) et l'état inverse du signal de signe de part et d'autre de la période d'horloge déterminée, lesdits premier et second signaux étant appliqués audit moyen d'amplification différentielle (742) qui produit le second signal d'erreur (ε7;ε8).

12. Comparateur de phase/fréquence (CP7;CP8) conforme à la revendication 11, caractérisé en ce que les moyens pour comparer les largeurs d'impulsions (70) comprennent des moyens (701) recevant les premières et secondes impulsions (IRa,Ib) pour établir un signal d'avance/retard ($Q_{701}$) dont les états sont représentatifs de l'avance et du retard du signal d'horloge (HR7;HR8) par rapport au signal d'entrée (SE7;SE8), et des moyens (702) pour détecter des transitions logiques dans le signal d'avance/retard ($Q_{701}$) en réponse au signal de détection de phase (SP;SPD) afin de produire le signal de signe (SF) en fonction du sens de chaque transition détectée.

13. Comparateur de phase/fréquence (CP7;CP8) conforme à la revendication 11 ou 12, caractérisée en ce que les moyens pour sélectionner sont un circuit logique 703 établissant des premier et second signaux tels que :

$$u = SP.IRa + \bar{\bar{SP}}.SF, \text{ et}$$

$$v = SP.Ib + \bar{\bar{SP}}.\bar{SF}$$

où SP et $\bar{\bar{SP}}$ dénotent le signal de détection de phase (SP;SPD) et le signal complémentaire de celui-ci, IRa et Ib dénotent des première et seconde impulsions sélectionnées, et SF et $\bar{\bar{SF}}$ dénotent le signal de signe et le signal complémentaire de celui-ci.

14. Circuit de récupération de rythme comprenant une boucle de verrouillage de phase incluant un comparateur de phase (CP) recevant le signal d'entrée numérique (SE) et le signal d'horloge (HR) pour produire un signal d'erreur (ε) et un oscillateur commandé en tension (VCO) recevant le signal d'erreur (ε) à travers des moyens de filtrage (FP) et produisant le signal d'horloge, caractérisé en ce que le comparateur de phase est un comparateur de phase/fréquence (CP5;CP6;CP7;CP8) conforme à l'une quelconque des revendications 1 à 13.

**Patentansprüche**

1. Phasen/Frequenzkomparator (CP5; CP7) mit Phasenvergleichseinrichtungen (CP2; CP4), die die Phasen eines digitalen Eingangssignales (SE5; SE7) mit einer vorgegebenen binären Periode (TE) und eines Zeitsignales (HR5; HR7) mit einer Zeitperiode (TH), die innerhalb eines vorgegebenen Zeitintervalles (2ΔΘ) bezüglich der binären Periode veränderlich ist, vergleicht, um ein erstes Fehlersignal (ε2; ε4) zu erzeugen, dessen Vorzeichen eine Funktion des Vorzeichens der Phasendifferenz zwischen dem Eingangssignal und dem Zeitsignal ist, dadurch gekennzeichnet, daß er Einrichtungen zur Auswertung der Phasenverschiebung (51; 751) zur Erkennung einer vorgegebenen Phasenverschiebung (ΔΦ) zwischen dem Zeitsignal (HR5; HR7) und dem Eingangssignal (SE5; SE7) im vorgegebenen Zeitintervall (2ΔΘ) während einer Zeitperiode (TH), um ein Phasendetektionssignal (SP5; SP7) zu erzeugen, und Einrichtungen (52; 70, 703) zur Modifizierung des ersten Fehlersignales in ein zweites Fehlersignal (ε5, ε7), dessen Vorzeichen eine Funktion des Vorzeichens der Differenz zwischen der binären Periode (TE) und der Zeitperiode (TH) ist, als Antwort auf das Phasendetektionssignal (SP5; SP7), aufweist.

2. Phasen/Frequenzkomparator (CP5; CP7) nach Anspruch 1, dadurch gekennzeichnet, daß die vorgegebene Phasenverschiebung (ΔΦ) im vorgegebenen Zeitintervall (2ΔΘ) gleich Null ist.

3. Phasen/Frequenzkomparator (CP5; CP7) nach Anspruch 1, dadurch gekennzeichnet, daß die Phasenauswerteeinrichtungen (51, 751) Einrichtungen (510, 511, 512) zur Entdeckung von Übergängen zwischen logischen Zuständen im Eingangssignal (SE5; SE7), um Übergangsimpulse (TI) mit einer Breite gleich dem vorgegebenen Zeitintervall (2ΔΘ) zu erzeugen, und Einrichtungen (513) zur Erzeugung eines Impulses des Phasendetektionssignales (SP5; SP7) mit einer Breite, die mindestens gleich einer Zeitperiode (TH) ist, als Antwort auf einen Übergangsimpuls (TI), der in Phase mit einem komplementären Zeitsignal ($\overline{HR5}$; $\overline{HR7}$) zum Zeitsignal ist, aufweisen.

4. Phasen/Frequenzkomparator (CP8) nach Anspruch 2, dadurch gekennzeichnet, daß die Phasenauswerteeinrichtungen mehrere vorgegebene Phasenverschiebungen (ΔΦ = ±ΔΘ; ΔΦ= TE/2 ±ΔΘ) zwischen dem Zeitsignal (HR8) und dem Eingangssignal (HE8) während mehrerer Zeitperioden (TH) erkennen.

5. Phasen/Frequenzkomparator (CP8) nach Anspruch 4, dadurch gekennzeichnet, daß die vorgegebenen Phasenverschiebungen gleich Null und Π im vorgegebenen Zeitintervall (2ΔΘ) sind.

6. Phasen/Frequenzkomparator (CP8) nach Anspruch 4 oder 5, dadurch gekennzeichnet, daß die Phasenauswerteeinrichtungen (851) Einrichtungen (510, 511, 512) zur Detektion von Übergängen zwischen logischen Zuständen im Eingangssignal (SE8), um Übergangsimpulse (TI) mit einer Breite gleich dem vorgegebenen Zeitintervall (2ΔΘ) zu erzeugen, Einrichtungen (513) zur Erzeugung eines Phasenimpulses (SP) mit einer Breite mindestens gleich einer Zeitperiode (TH) als Antwort auf einen Übergangsimpuls (TI), der genau in Phase mit einem komplementären Zeitsignal ($\overline{HR8}$) des Zeitsignals (HR8) ist, Einrichtungen (80) zur Erzeugung eines Gegenphasenimpulses (SD) mit einer Breite mindestens gleich einer Zeitperiode (TH) als Antwort auf einen Übergangsimpuls (TI), der genau in Phase mit dem Zeitsignal (HR7) ist, und Einrichtungen (81) zur Erzeugung eines Impulses des Phasendetektionssignales (SDP) genau zwischen dem Phasenimpuls (SP) und dem Gegenphasenimpuls (SD), aufweisen.

7. Phasen/Frequenzkomparator (CP5) nach einem der Ansprüche 1 bis 6, dadurch gekennzeichnet, daß die Einrichtungen zur Modifikation (52) Einrichtungen (521) zur Wiederherstellung mindestens einer Periode ($CL_{522}$) des Zeitsignales (HR5) als Antwort auf das Phasendetektionssignal (SP5) und Einrichtungen (522) zum Lesen des ersten Fehlersignales ($\varepsilon2$) als Antwort auf die reproduzierte Periode des Zeitsignales, um das zweite Fehlersignal ($\varepsilon5$) zu erzeugen, aufweisen.

8. Phasen/Frequenzkomparator (CP5) nach Anspruch 7, wobei die Phasenvergleichseinrichtungen (CP2) eine Kippschaltung (21) mit einem Dateneingang, der das Zeitsignal (HR5) empfängt, einem Zeiteingang, der das Zeitsignal (SE5) empfängt und einem Ausgang, der das erste Fehlersignal ($\varepsilon2$) überträgt, aufweisen.

9. Phasen/Frequenzkomparator (CP6) nach Anspruch 7, wobei die Phasenvergleichseinrichtungen (CP3) eine erste Kippstufe (30) mit einem Dateneingang, der das Eingangssignal (SE6) empfängt, und einem Zeiteingang, der das Zeitsignal (HR6) empfängt, und eine zweite Kippschaltung (31) mit einem Dateneingang, der das Eingangssignal (SE6) über eine Verzögerungsleitung (32) empfängt, die eine Verzögerung um eine binäre Halbperiode (TE/2) bewirkt, einem Zeiteingang, der mit einem Ausgang der ersten Kippstufe (30) verbunden ist, und einem Ausgang, der das erste Fehlersignal ($\varepsilon3$) überträgt, aufweisen.

10. Phasen/Frequenzkomparator (CP7; CP8) nach einem der Ansprüche 1 bis 6, dadurch gekennzeichnet, daß das zweite Fehlersignal ($\varepsilon7$; $\varepsilon8$) eine Amplitude aufweist, die im Vorzeichen und in der Größe als Funktion der Differenz zwischen der variablen Zeitperiode (TH) und der binären Periode (TE) variiert.

11. Phasen/Frequenzkomparator (CP7; CP8) nach einem der Ansprüche 1 bis 6 und 10, dadurch gekennzeichnet, daß

die Phasenvergleichseinrichtungen Einrichtungen (740a, 741a, 743) zur Erzeugung erster Impulse (IRa) mit einer Breite, die als Funktion der Phasenverschiebung (AV, RE) zwischen dem Zeitsignal (HR7; HR8) und dem Eingangssignal (SE7; SE8) variiert, Einrichtungen (740b, 741b) zur Erzeugung zweiter Impulse (Ib) mit einer Breite (TH/2), die proportional zur Zeitperiode ist, und eine differentielle Verstärkungseinrichtung (742) aufweisen, und

daß die Einrichtungen zur Modifikation Einrichtungen (70) zum Vergleich der Breiten der ersten und zweiten Impulse als Antwort auf das Phasendetektionssignal (SP; SPD), um ein Signal des logischen Vorzeichens (SF) zu erzeugen, dessen Zustände das Vorzeichen der Differenz zwischen der binären Periode (TE) und der Zweitperiode (TH) repräsentieren, und Einrichtungen (703) zur Auswahl erster und zweiter Impulse während mindestens einer Zeitperiode (TH) aufweisen, die durch das Phasendetektionssignal durch Erzeugung erster und zweiter Signale (u7, v7; u8, v8) bestimmt wird, die jeweils die ersten und zweiten in der bestimmten Zeitperiode enthaltenen ausgewählten Impulse und den Zustand des Vorzeichensignales (SF) und den inversen Zustand des Vorzeichensignales beiderseits der bestimmten Zeitperiode reproduzieren, wobei die ersten und zweiten Signale auf die differentielle Verstärkungseinrichtung (742) gegeben werden, die das zweite Fehlersignal ($\varepsilon7$, $\varepsilon8$) erzeugt.

12. Phasen/Frequenzkomparator (CP7, CP8) nach Anspruch 11, dadurch gekennzeichnet, daß die Einrichtungen zum Vergleich der Impulsbreiten (70) Einrichtungen (701), die die ersten und zweiten Impulse (IRa, Ib) empfangen, um ein Vorlauf/ Verzögerungssignal ($Q_{701}$) zu erzeugen, dessen Zustände repräsentativ sind für das Voreilen und die Verzögerung des Zeitsignales (HR7; HR8) bezüglich des Eingangssignales (SE7; SE8), und Einrichtungen (702) zur Detektion von logischen Übergängen im Vorlauf/Verzögerungssignal ($Q_{701}$) als Antwort auf das Phasendetektionssignal (SP; SPD), um das Vorzeichensignal (SF) als Funktion der Richtung jedes entdeckten Überganges zu erzeugen, aufweisen.

13. Phasen/Frequenzkomparator (CP7; CP8) nach Anspruch 11 oder 12, dadurch gekennzeichnet, daß die Auswahleinrichtungen eine logische Schaltung (703) sind, die erste und zweite Signale wie:

$$u = SP.IRa + \overline{SP}.SF,$$

und

$$v = SP.Ib + \overline{SP}.\overline{SF},$$

erzeugen, wobei SP und $\overline{SP}$ das Phasendetektionssignal (SP; SPD) und das dazu komplementäre Signal IRa und Ib erste und zweite ausgewählte Impulse und SF und $\overline{SF}$ das Vorzeichensignal und das dazu komplementäre Signal sind.

14. Taktrückgewinnungssystem mit einer Phasenverriegelungsschleife, die einen Phasenkomparator (CP), der das digitale Eingangssignal (SE) und das Zeitsignal (HR) empfängt, um ein Fehlersignal ($\varepsilon$) zu erzeugen, und einen spannungsgesteuerten Oszillator (VCO), der das Fehlersignal ($\varepsilon$) über Filtereinrichtungen (FP) empfängt und das Zeitsignal erzeugt, aufweist, dadurch gekennzeichnet, daß der Phasenkomparator ein Phasen/Frequenzkomparator (CP5; CP6; CP7; CP8) nach einem der Ansprüche 1 bis 13 ist.

## Claims

1. Phase/frequency comparator (CP5;CP7) comprising phase comparing means (CP2;CP4) comparing the phases of a digital input signal (SE5;SE7) having a predetermined binary period (TE) and of a clock signal (HR5;HR7) having a clock period (TH) variable to within a predetermined time interval (2$\Delta\Theta$) with respect to said binary period thereby producing a first error signal ($\varepsilon$2;$\varepsilon$4) whose sign is a function of the sign of the phase difference between the input signal and the clock signal, characterized in that it comprises phase shift assessing means (51;751) for detecting a predetermined phase shift ($\Delta\Phi$) between the clock signal (HR5;HR7) and the input signal (SE5;SE7) to within the predetermined time interval (2$\Delta\theta$) during a clock period (TH) thereby producing a phase detection signal (SP5;SP7), and means (52;70,703) for modifying the first error signal into a second error signal ($\varepsilon$5;$\varepsilon$7) of which the sign is a function of the sign of the difference between the binary period (TE) and the clock period (TH), in response to the phase detection signal (SP5;SP7).

2. Phase/frequency comparator (CP5;CP7) according to claim 1, characterized in that the predetermined phase shift ($\Delta\Phi$) is substantially equal to zero to within the predetermined time interval (2$\Delta\Theta$).

3. Phase/frequency comparator (CP5;CP7) according to claim 1, characterized in that the phase assessing means (51, 751) comprise means (510,511,512) for detecting transitions between logic states in the input signal (SE5;SE7) thereby producing transition pulses (TI) having a width substantially equal to the predetermined time interval (2$\Delta\Theta$), and means (513) for producing a pulse of the phase detection signal (SP5;SP7) having a width equal to at least one clock period (TH) in response to a transition pulse (TI) substantially in phase with a clock signal ($\overline{HR5},\overline{HR7}$) complementing said clock signal.

4. Phase/frequency comparator (CP8) according to claim 2, characterized in that the phase assessing means detect several predetermined phase shifts ($\Delta\Phi = \pm \Delta\Theta$ ; $\Delta\Phi = TE/2 \pm \Delta\Theta$) between the clock signal (HR8) and the input signal (HE8) during several respective clock periods (TH).

5. Phase/frequency comparator (CP8) according to claim 4, characterized in that the predetermined phase shifts are substantially equal to 0 and $\Pi$ to within the predetermined time interval (2$\Delta\Theta$).

6. Phase/frequency comparator (CP8) according to claim 4 or 5, characterized in that the phase assessing means (851) comprise means (510,511,512) for detecting transitions between logic states in the input signal (SE8) thereby producing transition pulses (TI) having a width substantially equal to the predetermined time interval (2$\Delta\Theta$), means (513) for producing a phase pulse (SP) having a width equal to at least one clock period (TH) in response to a transition pulse (TI) substantially in phase with a clock signal ($\overline{HR8}$) complementing said clock signal (HR8), means (80) for producing an opposite phase pulse (SD) having a width at least equal to one clock period (TH) in response to a transition pulse (TI) substantially in phase with said clock signal (HR7), and means (81) for producing a pulse of the phase detection signal (SDP) substantially between the phase pulse (SP) and the opposite phase pulse (SD).

7. Phase/frequency comparator (CP5) according to any one of claims 1 to 6, characterized in that the modifying means (52) comprise means (521) for reproducing at least one period (CL$_{522}$) of the clock signal (HR5) in response to the phase detection signal (SP5), and means (522) for reading the sign of the first error signal ($\varepsilon$2) in response to the reproduced clock signal period thereby deriving the second error signal ($\varepsilon$5).

8. Phase/frequency comparator (CP5) according to claim 7, wherein the phase comparing means (CP2) comprise a flip-flop (21) having a data input receiving the clock signal (HR5), a clock input receiving the clock signal (SE5), and an output transmitting the first error signal ($\varepsilon$2).

9. Phase/frequency comparator (CP6) according to claim 7, wherein the phase comparing means (CP3) comprise a first flip-flop (30) having a data input receiving the input signal (SE6) and a clock input receiving the clock signal (HR6), and a second flip-flop (31) having a data input receiving the input signal (SE6) via a delay line (32) conferring a lag of a binary half-period (TE/2), a clock input connected to an output of the first flip-flop (30), and an output transmitting the first error signal (ε3).

10. Phase/frequency comparator (CP7;CP8) according to any one of claims 1 to 6, characterized in that the second error signal (ε7 ; ε8) has an amplitude of sign and magnitude varying as a function of the difference between the variable clock period (TH) and the binary period (TE).

11. Phase/frequency comparator (CP7;CP8) according to any one of claims 1 to 6 and 10, characterized in that

   the phase comparing means comprise means (740a,741a,743) for deriving first pulses (IRa) having widths that vary as a function of the phase shift (AV,RE) between the clock signal (HR7;HR8) and the input signal (SE7;SE8), means (740b,741b) for deriving second pulses (Ib) having widths (TH/2) proportional to the clock period, and a differential amplification means (742), and
   in that the modifying means comprise means (70) for comparing the widths of first and second pulses in response to the phase detection signal (SP;SPD) thereby producing a logic sign signal (SF) of which the states are representative of the sign of the difference between the binary period (TE) and the clock period (TH), and means (703) for selecting first and second pulses during at least one clock period (TH) determined by the phase detection signal thereby producing first and second signals (u7,v7;u8;v8) respectively reproducing the first and second selected pulses contained in the determined clock period and the state of the sign signal (SF) and the opposite state of the sign signal before and after the determined clock period, said first and second signals being applied to said differential amplification means (742) which produces the second error signal (ε7;ε8).

12. Phase/frequency comparator (CP7;CP8) according to claim 11, characterized in that the pulse width comparing means (70) comprise means (701) receiving the first and second pulses (IRa,Ib) for deriving an advance/lag signal ($Q_{701}$) of which the states are representative of the advance and lag of the clock signal (HR7;HR8) with regard to the input signal (SE7;SE8), and means (702) for detecting logic transitions in the advance/lag signal ($Q_{701}$) in response to the phase detection signal (SP;SPD) thereby producing the sign signal (SF) as a function of direction of each transition detected.

13. Phase/frequency comparator (CP7;CP8) according to claim 11 or 12, characterized in that the selecting means are a logic circuit (703) deriving first and second signals such that:

$$u = SP.IRa + \overline{SP}.SF, \text{ and}$$

$$v = SP.Ib + \overline{SP}.\overline{SF}$$

   where SP and $\overline{SP}$ denote the phase detection signal (SP;SPD) and the complementary signal thereof, IRa and Ib denote first and second selected pulses, and SF and $\overline{SF}$ denote the sign signal and the complementary signal thereof.

14. Timing recovering circuit comprising a phase locked loop including a phase comparator (CP) receiving the digital input signal (SE) and the clock signal (HR) for producing an error signal (ε) and a voltage-controlled oscillator (VCO) receiving the error signal (ε) through filtering means (FP) and producing the clock signal, characterized in that the phase comparator is a phase/frequency comparator (CP5; CP6;CP7;CP8) according to any one of claims 1 to 13.

*FIG.1*
TECHNIQUE ANTERIEURE

*FIG.2A*
TECHNIQUE ANTERIEURE

*FIG.3*
TECHNIQUE ANTERIEURE

*FIG.4A*
TECHNIQUE ANTERIEURE

# FIG.2B

HR2, HR5

SE2, SE5

$\mathcal{E}2$

TH

AV

TE

RE

V1 — S1

$\overline{VM}$ — VO — S0

AV ,"0"    RE ,"1"

# FIG.2C

HR2, HR5

SE2, SE5

$\mathcal{E}2$

TH

RE

TE

AV

RE,"1"    AV,"0"

# FIG.5B

TI

SP5

CL$_{522}$

$\mathcal{E}5$

$2\Delta\theta$

TH

TH/2

"0",FE5−FH5>0

# FIG.5C

TI

SP5

CL$_{522}$

$\mathcal{E}5$

$2\Delta\theta$

"1",FE5−FH5<0

EP 0 500 473 B1

*FIG.4B*

*FIG.4C*

# FIG.5A

HR5

SE5

CP2

D    Q  ──→ SR5

CL    20

D    Q

CL    21

CIRCUIT DE VALIDATION DU
SIGNAL D'ERREUR          CP5

ε2

D    Q  ──→ ε5

CL    522

521                              52

SP5

$\overline{HR5}$    514

511
∫ S1    L1

512

510
∫ S0    L0

$TI$    D    Q

CL    513

51

CIRCUIT D'EVALUATION DE DEPHASAGE

EP 0 500 473 B1

# FIG.5D

# FIG.5E

## FIG.6

SE6

HR6

CP3

D   Q — SR6

CL        30

TE/2

32

D   Q

CL   31

ε3

CP6

CIRCUIT DE VALIDATION DU
SIGNAL D'ERREUR

D   Q — ε6

CL
521    522

52

CIRCUIT D'EVALUATION DE DEPHASAGE

∫ S1    511

∫ S0
510

512

TI

$\overline{HR6}$

514

D   Q

CL   513

SP6

51

EP 0 500 473 B1

FIG.7A

$u7 = SP7.IRa + \overline{SP7}.SF$

$v7 = SP7.Ib + \overline{SP7}.\overline{SF}$

CIRCUIT LOGIQUE (PLA) — 703

742 — ε7

TE/2 — 743

IRa

Ib

Ia

SF

SP7

702 — Q, D, CL

701 — Q, D, CL — Q701

704 — $\overline{SP7}$

70

CIRCUIT DE DETECTION DE SIGNE D'ECART DE FREQUENCE

CP7

741a

741b

740a — D, Q, CL

740b — D, Q, CL

SRa

SR7

SE7

HR7

$\overline{HR7}$

751

SP7

513 — D, Q, CL

512 — TI

511 — ∫ S1

510 — ∫ S0

514

CIRCUIT D'EVALUATION DE DEPHASAGE

*FIG.7B*

FE7−FH7>0

EP 0 500 473 B1

*FIG.7C*

FE7−FH7<0

# FIG.7D

CV7

CV4

CV7

FE7−FH7>0

−Δθ   0   Δθ   TE/2   TE−Δθ   TE   TE+Δθ   2TE−Δθ   2TE   Δφ

# FIG.7E

CV7

CV4

−Δθ   0   Δθ   TE/2   TE−Δθ   TE   TE+Δθ   2TE−Δθ   2TE   Δφ

CV7

FE7−FH7<0

EP 0 500 473 B1

FIG.8A

$u8 = SPD.IRa + \overline{SPD}.SF$

$v8 = SPD.Ib + \overline{SPD}.\overline{SF}$

EP 0 500 473 B1

*FIG.8B*

*FIG.8C*